# EUROPÄISCHE PATENTSCHRIFT

(11) **EP 3 274 385 B1**
(45) Veröffentlichungstag und Bekanntmachung des Hinweises auf die Patenterteilung: **04.12.2019**
(21) Anmeldenummer: 16714320.5
(22) Anmeldetag: 23.03.2016
(51) Int. Cl.: C08F 279/04, C08L 25/12, C08L 55/02, C08F 2/38, C08F 2/26

(54) **VERFAHREN ZUR HERSTELLUNG THERMOPLASTISCHER POLYMERZUSAMMENSETZUNGEN MIT OPTIMIERTEM VERNETZUNGSGRAD**
PROCESS FOR PRODUCING THERMOPLASTIC POLYMER COMPOSITIONS WITH OPTIMIZED DEGREE OF CROSSLINKING
PROCÉDÉ POUR PRODUIRE DES COMPOSITIONS POLYMÈRES THERMOPLASTIQUES AYANT UN DEGRÉ DE RÉTICULATION OPTIMISÉ

(30) Priorität: 25.03.2015 EP 15160878
(43) Veröffentlichungstag der Anmeldung: 31.01.2018
(73) Patentinhaber: INEOS Styrolution Group GmbH, 60325 Frankfurt (DE)
(72) Erfinder: BANASZAK, Brian J., 68161 Mannheim (DE); WALKER, Roland, 49076 Osnabrück (DE); SEDA, Libor, 36001 Karlovy Vary (CZ); BARTH, Johannes, 63110 Rodgau (DE); MICHELS, Gisbert, 51375 Leverkusen (DE); NESTLE, Nikolaus, 69123 Heidelberg (DE)
(74) Vertreter: Jacobi, Markus Alexander
(86) Internationale Anmeldenummer: PCT/EP2016/056344
(87) Internationale Veröffentlichungsnummer: WO 2016/150999

(56) Entgegenhaltungen:
- EP-A1- 0 022 200
- WO-A2-2008/020012
- JP-A- 2001 011 283

## Beschreibung

Offenbart wird ein Verfahren zur Herstellung thermoplastischer Polymerzusammensetzungen (Formmassen) mit optimiertem Vernetzungsgrad. Die Erfindung befasst sich mit einem Verfahren zur Herstellung von Copolymeren, insbesondere PfropfCopolymeren, mit optimiertem Vernetzungsgrad.

Es ist seit Jahrzehnten bekannt, thermoplastische Polymerzusammensetzungen herzustellen, indem man thermoplastische Polymere durch Einarbeiten von Elastomeren (Kautschuken) modifiziert, um so schlagzäh-modifizierte thermoplastische Zusammensetzungen zu erhalten. Dies geschieht zum Beispiel durch Pfropfmischpolymerisation von Styrol und Acrylnitril in Gegenwart eines Kautschuks sowie durch nachträgliches Abmischen dieses Pfropfcopolymers mit einer separat hergestellten polymeren Matrix, die zum Beispiel aus einem Styrol-Acrylnitril-Copolymer oder einem Methylstyrol-Acrylnitril-Copolymer bestehen kann.

Elastomere zeichnen sich dadurch aus, dass sie formfest, aber elastisch verformbar sind. Ihr Glasübergangspunkt liegt unterhalb der normalen Einsatztemperatur. Diese Eigenschaften werden dadurch erzielt, dass die einzelnen Polymerketten des Elastomers durch kovalente Bindungen miteinander verknüpft werden. Man spricht dann von einem vernetzten Polymer. Der Vernetzungsgrad ist maßgeblich für die Eigenschaften des Polymers verantwortlich. Dabei ist zu beobachten, dass in vergleichbaren Systemen mit steigendem Vernetzungsgrad die Materialien steifer, härter und korrosionsbeständiger werden, im Gegenzug aber auch eher unerwünschte Eigenschaften, wie Sprödheit des Materials, zunehmen. Als Elastomere werden Polymere mit einem mittleren Vernetzungsgrad bezeichnet, während Thermoplaste häufig einen geringen Vernetzungsgrad und Duroplaste einen hohen Vernetzungsgrad aufweisen.

Der Vernetzungsgrad ist ein quantitatives Maß zur Charakterisierung von polymeren Netzwerken. Er wird z. B. berechnet als Quotient aus der Molzahl vernetzter Grundbausteine und der Molzahl der insgesamt in diesem makromolekularen Produkt (Netzwerk) vorhandenen Grundbausteine.
Er wird entweder als dimensionslose Zahl oder in Prozent (Stoffmengenanteil) angegeben. Davon abzugrenzen ist die Vernetzungsdichte eines Polymers, welche die Zahl der Vernetzungsstellen bezogen auf das Volumen angibt.

Der maximale Vernetzungsgrad eines Polymers ergibt sich aus der Rezeptur des polymeren Netzes. Dieser stellt einen theoretischen Vernetzungsgrad dar, welcher in der Praxis fast nie erreicht wird, da während der Polymerisation (Netzwerksbildung), u.a. wegen der auftretenden räumlichen Hinderung, nicht alle vernetzungsfähigen Bausteine einen Reaktionspartner finden und auch die weiteren Reaktionsbedingungen Einfluss auf die Vernetzung nehmen können.

Der theoretische Vernetzungsgrad errechnet sich aus der Zusammensetzung des Monomeren-Gemisches. Der tatsächlich erhaltene Vernetzungsgrad kann im Anschluss an die Polymerisation analytisch bestimmt werden, beispielsweise mittels spektroskopischer Methoden, wie NMR-Spektroskopie (vgl. K. Saalwächter, Progress in Nuclear Magnetic Resonance Spectroscopy, 2007, 51, S. 1-35; R. Kimmich, N. Fatkullin, Advances in Polymer Science, 2004, 170, S. 1-113).

WO 2013/060914 befasst sich mit der Charakterisierung eines elastomeren Latex mittels Niedrigfeld-NMR-Spektroskopie. Darin werden Naturkautschuk-Latices im Hinblick auf ihre Netzwerkstruktur mittels Double-Quantum-Coherence-Spektroskopie während verschiedener Verarbeitungsschritte des Naturkautschuks untersucht.

EP-A 0022200 und JP-A 2001/011283 lehren Butadien-Styrol-Copolymere (ABS), deren Herstellung und die Bestimmung von Relaxationszeiten hierbei mittels NMR-Messungen. WO 2008/020012 lehrt die Herstellung von ABS einschließlich der Agglomerisierung der Latexpartikel.

In Analytica Chimica Acta, Vol. 604, 2007, Seiten 54-61 wird die Untersuchung von Styrol-Butadien-Styrol-Blockcopolymeren mittels Niedrigfeld-Time-Domain-NMR-Spektroskopie beschrieben.

Um Elastomere mit gezielten Eigenschaften planmäßig herstellen zu können, ist es daher wichtig, das Verfahren zur Herstellung von vernetzten Polymeren exakt zu steuern. Da eine Vielzahl von Faktoren Einfluss auf die Vernetzungsreaktionen haben, kann dies auf unterschiedliche Weise erfolgen, wie z.B. durch Steuerung der Reaktionstemperatur oder durch Zugabe von Molekulargewichtsreglern wie z.B. Vernetzungsmitteln und Kettentransfer-Reagenzien.
Üblicherweise werden solche Molekulargewichtsregler den Polymerisationsgemischen in einer Menge von 0 bis 3 Gew.-% zugesetzt. Insbesondere Kettentransfer-Reagenzien stellen häufig einen Faktor dar, der im Hinblick auf die Schadstoffbelastung der Kunststoffe und unerwünschte Eigenschaften reduziert werden sollte.

Aufgrund der vielfältigen Einflüsse auf den Vernetzungsgrad eines Polymers während der Polymerisations-Reaktion ist die Regulierung des Vernetzungsgrades in künstlichen Elastomeren problematisch. Die Eigenschaften werden sowohl durch die Edukte, als auch durch die Additive, die Reaktionsdauer, die Reaktionstemperatur und weitere Parameter wie den Verzweigungsgrad beeinflusst. Es erscheint daher notwendig ein Verfahren bereitzustellen, welches es ermöglicht, den Vernetzungsgrad einer elastomeren Komponente zu bestimmen und das Polymerisationsverfahren daran anzupassen, um so Polymere mit optimierten Eigenschaften zu erhalten. Ferner sollte auch eine Reduktion der zuzugebenden Kettentransfer-Reagenzien erreicht werden.

Eine Aufgabe der vorliegenden Erfindung ist es, ein Verfahren bereitzustellen, mit dem eine Polymerzusammensetzung hergestellt werden kann, welche optimierte mechanische Eigenschaften aufweist, und bei dem gleichzeitig ein geringer Gehalt an Kettenübertragungs-Reagenz eingesetzt wird. Die Aufgabe wird durch das Verfahren gemäß den Ansprüchen gelöst.

Gelehrt wird ein Verfahren zur Herstellung einer thermoplastischen Polymerzusammensetzung (A), enthaltend mindestens ein Styrol-Copolymer (a) und mindestens einen polymeren Schlagzähmodifikator (b), umfassend ein Copolymer (b1) als Pfropfgrundlage und mindestens eine Pfropfauflage (b2) sowie ggf. weitere Additive (C). Das Verfahren umfasst die folgenden Schritte:
(1) Bereitstellen eines vernetzten Copolymers (b1) durch die Polymerisation eines Monomeren-Gemisches, umfassend:
   (b11): 70 bis 99,99 Gew.-% mindestens eines konjugierten Diens und/oder mindestens eines Acrylats,
   (b12): 0 bis 29 Gew.-% mindestens eines weiteren Comonomers ausgewählt aus: Styrol, α-Methylstyrol, Acrylnitril, Methacrylnitril und Methylmethacrylat,
   (b13): 0 bis 10 Gew.-% eines oder mehrerer polyfunktioneller, vernetzender Monomere, und
   (b14): 0,01 bis 0,7 Gew.-% eines Kettenübertragungs-Reagenzes,
   bezogen auf die gesamte Monomer-Menge des Polymerisationsgemischs zur Herstellung des Copolymers (b1);
(2) Aufbringen mindestens einer Pfropfauflage (b2) auf das Copolymer (b1) durch die Polymerisation eines Monomeren-Gemisches, umfassend:
   (b21): 65 bis 95 Gew.-% mindestens eines vinylaromatischen Monomeren,
   (b22): 5 bis 35 Gew.-% Acrylnitril und/oder Methacrylnitril, und
   (b23): 0 bis 30 Gew.-% mindestens eines weiteren monoethylenisch ungesättigten Monomeren ausgewählt aus: Methylmethacrylat (MMA), Maleinsäureanhydrid (MSA) und N-Phenylmaleinimid (N-PMI),
   bezogen auf die gesamte Monomer-Menge des Polymerisationsgemischs zur Herstellung der Pfropfauflage (b2),
   in Gegenwart des Copolymers (b1) als Pfropfgrundlage, um so den Schlagzähmodifikator (b) zu bilden; und
(3) Vermischen des mindestens einen Styrol-Copolymers (a) und des mindestens einen Schlagzähmodifikators (b), um so die Polymerzusammensetzung (A) zu erhalten.

Die Erfindung betrifft auch ein Verfahren, bei dem die Konzentration des Kettenübertragungs-Reagenzes (b14) bezogen auf die gesamte Monomer-Menge des Polymerisationsgemischs zur Herstellung des Copolymers (b1) 0,1 bis 0,6 Gew.-% beträgt.

Die Erfindung betrifft auch ein Verfahren, bei dem zur Bereitstellung des Copolymers (b1) dem Reaktions-Gemisch der Polymerisations-Reaktion ein Kettenübertragungs-Reagenz (b14) aus der Gruppe umfassend Mercaptane, Phosphinate, Bisulfite, Terpinole und dimeres α-Methylstyrol und Gemische der Genannten zugegeben wird.

Die Erfindung betrifft auch ein Verfahren, bei dem zur Bereitstellung des Copolymers (b1) dem Reaktions-Gemisch der Polymerisations-Reaktion als zusätzliches polyfunktionelles, vernetzendes Monomer (b13) mindestens ein bi-funktionelles Monomer mit mindestens zwei reaktiven, ungesättigten Gruppen aus der Gruppe umfassend Ethylenglykoldiacrylat, Butandioldiacrylat, Hexandioldiacrylat, Ethylenglykoldimethacrylat, Butandioldimethacrylat, Hexandioldimethacrylat, Divinylbenzol, Diallylmaleat, Diallylfumarat, Diallylphthalat, Diallylcyanurat, Tris-allyl-cyanurat, Tricyclodecenylacrylat, Dihydrodicyclopentadienylacrylat, Diallylphosphat, Allylacrylat, Allylmethacrylat (AMA), Dicyclopentadienylacrylat (DCPA) und Gemischen der Genannten zugegeben wird.

Gelehrt wird ferner eine thermoplastische Polymerzusammensetzung (A), welche nach dem beschriebenen Verfahren erhältlich ist bzw. erhalten wurde.

Gelehrt wird auch eine Polymerzusammensetzung (A), welche ein Styrol/Acrylnitril-Copolymer (SAN) als Styrol-Copolymer (a) enthält, sowie ein Butadien-haltiges Copolymer oder ein Acrylat-haltiges Copolymer als polymeren Schlagzähmodifikator (b).

Gelehrt wird ferner die Verwendung der thermoplastischen Polymerzusammensetzung (A) zur Herstellung von Formteilen, Folien oder Beschichtungen.

Gegenstand der Erfindung ist ein Verfahren zur Optimierung des Vernetzungsgrades (V) eines vernetzten Copolymers (b1) als Pfropfgrundlage für einen polymeren Schlagzähmodifikator (b), hergestellt aus einem Monomeren-Gemisch, umfassend:
(b11): 70 bis 99,99 Gew.-% mindestens eines konjugierten Diens und/oder mindestens eines Acrylats,
(b12): 0 bis 29 Gew.-% mindestens eines weiteren Comonomers ausgewählt aus Styrol, α-Methylstyrol, Acrylnitril, Methacrylnitril und Methylmethacrylat,
(b13): 0 bis 10 Gew.-% eines oder mehrerer polyfunktioneller, vernetzender Monomere, und
(b14): 0,01 bis 0,7 Gew.-% eines Kettenübertragungs-Reagenzes,
bezogen auf die gesamte Monomer-Menge des Polymerisationsgemischs zur Herstellung des Copolymers (b1),
wobei das Verfahren die folgenden Schritte umfasst:
(i) Polymerisieren des Monomeren-Gemisches zur Herstellung des Copolymers (b1);
(ii) Bestimmen des Vernetzungsgrades (V) des in Schritt (i) erhaltenen Copolymers (b1) mittels NMR-Relaxationsmessungen;
(iii) Polymerisieren eines modifizierten Monomeren-Gemisches zur Herstellung eines modifizierten Copolymers (b1'), wobei die Parameter der Polymerisations-Reaktion in Abhängigkeit des gemäß Schritt (ii) ermittelten Vernetzungsgrads (V) des Copolymers (b1) und des gewünschten Vernetzungsgrads (V') des Copolymers (b1') als Pfropfgrundlage angepasst werden; und
(iv) gegebenenfalls Wiederholen der Schritte (i) bis (iii), bis ein gewünschter Vernetzungsgrad (V') erreicht wird,
wobei das Verfahren gemäß der vorliegenden Erfindung ferner gemäß den Ansprüchen charakterisiert ist.

Die Erfindung betrifft daher ferner ein Verfahren, bei dem zur Bestimmung des Vernetzungsgrades (V) des Copolymers (b1) die transversale Relaxationszeit T2 verwendet wird.

Die Erfindung betrifft daher auch ein Verfahren, bei dem die Bestimmung des Vernetzungsgrades (V) des Copolymers (b1) unter Verwendung eines Niedrigfeld-NMR-Spektrometers bei einer Feldstärke im Bereich von 0,001 bis 1,5 Tesla, vorzugsweise 0,1 bis 0,6 Tesla erfolgt.

Die Erfindung betrifft auch ein Verfahren, bei dem zur Bereitstellung des Copolymers (b1') in Abhängigkeit des aus der ersten Polymerisations-Reaktion gemäß Schritt (ii) bestimmten Vernetzungsgrades (V) des Copolymers (b1) dem Reaktions-Gemisch der Polymerisations-Reaktion gemäß Schritt (iii) zusätzlich ein polyfunktionelles, vernetzendes Monomer (b13) als Vernetzungsmittel und/oder ein Kettenübertragungs-Reagenz (b14) zugegeben wird, oder die Reaktionstemperatur bei der Polymerisations-Reaktion verändert wird, oder eine Kombinationen dieser Maßnahmen erfolgt.

Die Erfindung betrifft auch ein Verfahren, bei dem zur Bereitstellung des Copolymers (b1') das Reaktions-Gemisch der Polymerisations-Reaktion einer Temperatur-Änderung von mindestens 10°C unterzogen wird.

Die Erfindung betriff auch ein Verfahren bei dem dem Reaktionsgemisch ein Kettenübertragungs-Reagenz in einer Konzentration von 0,1 bis 0,6 Gew.-%, bezogen auf die gesamte Monomer-Menge des Polymerisationsgemischs zur Herstellung des Copolymers (b1'), zugefügt wird.

Ferner wird auch die Verwendung des beschriebenen Verfahrens zur Herstellung eines Copolymers (b1') mit optimiertem Vernetzungsgrad (V') gelehrt.

Die gelehrte thermoplastische Polymerzusammensetzung (A) kann bevorzugt aus den polymeren Komponenten (a) und (b) bestehen:
(a): 30 bis 95 Gew.-%, bezogen auf die Polymerzusammensetzung (A), mindestens eines Styrol-Copolymers (a) mit einer gewichtsmittleren Molmasse Mw von 150.000 bis 360.000 g/mol, ausgewählt aus Vinylaromat-Copolymeren, ausgewählt aus der Gruppe bestehend aus:
   Styrol-Acrylnitril-Copolymeren, α-Methylstyrol-Acrylnitril-Copolymeren, Styrol-Maleinsäureanhydrid-Copolymeren, Styrol-Phenylmaleinimid-Copolymeren, Styrol-Methylmethacrylat-Copolymeren, Styrol-Acrylnitril-Maleinsäureanhydrid-Copolymeren, Styrol-Acrylnitril-Phenylmaleinimid-Copolymeren, α-Methylstyrol-Acrylnitril-Methylmethacrylat-Copolymeren, α-Methylstyrol-Acrylnitril-t-Butylmethacrylat-Copolymeren und Styrol-Acrylnitril-t-Butylmethacrylat-Copolymeren,
(b): 5 bis 70 Gew.-%, bezogen auf die Polymerzusammensetzung (A), mindestens eines Schlagzähmodifikators (b), bestehend aus:
   (b1): 20-90 Gew.-%, bezogen auf den Schlagzähmodifikator (b), eines Copolymers eines oder mehrerer Monomere als Pfropfgrundlage, erhalten durch Copolymerisation eines Monomeren-Gemisches, umfassend:
      (b11): 70 bis 99,99 Gew.-% mindestens eines konjugierten Diens und/oder mindestens eines Acrylats,
      (b12): 0 bis 29 Gew.-% mindestens eines weiteren Comonomers ausgewählt aus: Styrol, α-Methylstyrol, Acrylnitril, Methacrylnitril, und Methylmethacrylat,
      (b13): 0 bis 10 Gew.-% eines oder mehrerer polyfunktioneller, vernetzender Monomere, und
      (b14): 0,01 bis 0,7 Gew.-% eines Kettenübertragungs-Reagenzes, bezogen auf die gesamte Monomer-Menge des Polymerisationsgemischs zur Herstellung des Copolymers (b1);
   (b2): 10 bis 80 Gew.-%, bezogen auf den Schlagzähmodifikator (b), einer Pfropfauflage eines oder mehrerer Monomere, bestehend aus:
      (b21): 65 bis 95 Gew.-%, bevorzugt 70 bis 90 Gew.-%, besonders bevorzugt 75 bis 85 Gew.-% mindestens eines vinylaromatischen Monomeren, vorzugsweise Styrol und/oder α-Methylstyrol, insbesondere Styrol,
      (b22): 5 bis 35 Gew.-%, bevorzugt 10 bis 30 Gew.-%, besonders bevorzugt 15 bis 25 Gew.-% Acrylnitril und/oder Methacrylnitril, vorzugsweise Acrylnitril, und
      (b23): 0 bis 30 Gew.-%, bevorzugt 0 bis 20 Gew.-%, besonders bevorzugt 0 bis 15 Gew.-% mindestens eines weiteren monoethylenisch ungesättigten Monomeren ausgewählt aus: MMA, MSA und N-PMI,
      bezogen auf die gesamte Monomer-Menge des Polymerisationsgemischs zur Herstellung der Pfropfauflage (b2);
   wobei die Summe aus Styrol-Copolymer (a) und Schlagzähmodifikator (b) 100 Gew.-% ergibt.

Die Viskosität (gemessen nach ISO 11443) der Polymerzusammensetzung (A) bei Scherraten von 1 bis 10 s⁻¹ und bei Temperaturen von 250 °C ist vorzugsweise nicht höher als 1x10⁵ Pa*s.

Die Melt Volume Rate (MVR, gemessen nach ISO 1133 bei 220°C und 10 kg Last) beträgt vorzugsweise mehr als 6 ml/10 min.

Die Bestimmung der gewichtsmittleren Molmasse Mw erfolgt mittels bekannter Verfahren der GPC mit UV-Detektion.

Bevorzugt beträgt in der thermoplastischen Polymerzusammensetzung (A) der Anteil des Polymers (a) 40 bis 90 Gew.-% und der Anteil des Schlagzähmodifikators (b) 60 bis 10 Gew.-%. Besonders bevorzugt beträgt in der Polymerzusammensetzung (A) der Anteil des Polymers (a) 50 bis 80 Gew.-% und der Anteil des Schlagzähmodifikators (b) 50 bis 20 Gew.-%. Insbesondere beträgt in der Polymerzusammensetzung (A) der Anteil des Polymers (a) 60 bis 75 Gew.-% und der Anteil des Schlagzähmodifikators (b) 40 bis 25 Gew.-%.

### Styrol-Copolymer (a)

Das Styrol-Copolymer (a) bildet eine Hartphase mit einer Glasübergangstemperatur TG von > 20°C. Die gewichtsmittleren Molmassen Mw der Styrol-Copolymere (a) betragen üblicherweise 150.000 bis 360.000 g/mol, bevorzugt 150.000 bis 300.000 g/mol, besonders bevorzugt 150.000 bis 270.000 g/mol, ganz besonders bevorzugt 150.000 bis 250.000 g/mol, insbesondere 150.000 bis 220.000 g/mol.

Als Styrol-Copolymer (a) sind Vinylaromat-Copolymere, ausgewählt aus der Gruppe bestehend aus Styrol-Acrylnitril-Copolymeren, α-Methylstyrol-Acrylnitril-Copolymeren, Styrol-Maleinsäureanhydrid-Copolymeren, Styrol-Phenyl-maleinimid-Copolymeren, Styrol-Methylmethacrylat-Copolymeren, Styrol-Acrylnitril-Maleinsäureanhydrid-Copolymeren, Styrol-Acrylnitril-Phenylmaleinimid-Copolymeren, α-Methylstyrol-Acrylnitril-Methylmethacrylat-Copolymeren, α-Methylstyrol-Acrylnitril-t-Butylmethacrylat-Copolymeren und Styrol-Acrylnitril-t-Butylmethacrylat-Copolymereneinsetzbar.

Bei den vorgenannten Polymeren (a) handelt es sich vorzugsweise um amorphe Polymere. Bevorzugt verwendet werden als Styrol-Copolymer (a) Styrol-Acrylnitril-Copolymere (SAN), Styrol-Methylmethacrylat-Copolymere (SMMA) und/oder Styrol-Maleinsäureanhydrid-Copolymere (SMSA). Bevorzugt sind Styrol-Acrylnitril-Copolymere (SAN).

Als Styrol-Copolymer (a) eingesetztbare SAN-Copolymere und α-Methylstyrol-Acrylnitril-Copolymere (AMSAN) enthalten im Allgemeinen 18 bis 35 Gew.-%, bevorzugt 20 bis 32 Gew.-%, besonders bevorzugt 22 bis 30 Gew.-% Acrylnitril (AN), und 82 bis 65 Gew.-%, bevorzugt 80 bis 68 Gew.-%, besonders bevorzugt 78 bis 70 Gew.-% Styrol (S) bzw. α-Methylstyrol (AMS), wobei die Summe aus Styrol bzw. α-Methylstyrol und Acrylnitril 100 Gew.-% ergibt.

Die eingesetzten SAN und AMSAN-Copolymere weisen im Allgemeinen eine gewichtsmittlere Molmasse Mw von 150.000 bis 350.000 g/mol, bevorzugt 150.000 bis 300.000 g/mol, besonders bevorzugt 150.000 bis 250.000 g/mol, und ganz besonders bevorzugt 150.000 bis 200.000 g/mol auf.

Als Styrol-Copolymer (a) einsetzbare SMMA-Copolymere enthalten im Allgemeinen 18 bis 50 Gew.-%, bevorzugt 20 bis 30 Gew.-% Methylmethacrylat (MMA), und 50 bis 82 Gew.-%, bevorzugt 80 bis 70 Gew.-% Styrol, wobei die Summe aus Styrol und MMA 100 Gew.-% ergibt.

Als Styrol-Copolymer (a) einsetzbare SMSA-Copolymere enthalten im Allgemeinen 10 bis 40 Gew.-%, bevorzugt 20 bis 30 Gew.-% Maleinsäureanhydrid (MSA), und 60 bis 90 Gew.-%, bevorzugt 80 bis 70 Gew.-% Styrol, wobei die Summe aus Styrol und MSA 100 Gew.-% ergibt.

Das Styrol-Copolymer (a) hat eine Viskositätszahl VZ (ermittelt nach DIN 53 726 bei 25°C, an einer 0,5 Gew.-%igen Lösung des Polymers (A) in Dimethylformamid) von 50 ml/g bis 120 ml/g, bevorzugt 52 ml/g bis 100 ml/g und besonders bevorzugt 55 ml/g bis 80 ml/g.

Die Styrol-Copolymere (a) werden in bekannter Weise durch Masse-, Lösungs-, Suspensions-, Fällungs- oder Emulsionspolymerisation erhalten, wobei Masse- und Lösungspolymerisation bevorzugt sind. Einzelheiten dieser Verfahren sind z. B. im Kunststoffhandbuch, Hrg. R. Vieweg und G. Daumiller, Bd. 4 "Polystyrol", Carl-Hanser-Verlag München 1996, S. 104 ff sowie in "Modern Styrenic Polymers: Polystyrenes and Styrenic Copolymers" (Eds., J. Scheirs, D. Priddy, Wiley, Chichester, UK, (2003), Seiten 27 bis 29) und in GB-A 1472195 beschrieben.

Als SAN-Copolymere geeignet sind handelsübliche SAN-Copolymere wie beispielsweise Luran® von der Firma Styrolution (Frankfurt). Bevorzugt werden SAN-Copolymere mit einem S/AN-Verhältnis (in Gewichtsprozent) von 81/19 bis 67/33 und einem MVR (gemessen nach ISO 1133 bei 220°C und 10 kg Last) von mindestens 10 ml/10 min eingesetzt, wie beispielsweise Luran 368.

### Polymerer Schlagzähmodifikator (b)

Der Schlagzähmodifikator (b) bildet eine Weichphase mit einer Glasübergangstemperatur TG von < 0°C, vorzugsweise < -20°C, besonders bevorzugt < -40°C.

Die Teilchengröße der Schlagzähmodifikatoren (b) beträgt im Allgemeinen mindestens 50 nm und höchstens 8 µm, bevorzugt 60 nm bis 5 µm, besonders bevorzugt 80 nm bis 3 µm, ganz besonders bevorzugt 80 nm bis 2 µm. Es können erfindungsgemäße Schlagzähmodifikatoren (b) mit bi-, tri- oder multimodalen Teilchengrößenverteilungen hergestellt werden.

Erfindungsgemäß enthält der Schlagzähmodifikator (b) oftmals:
(b1): 20 bis 90 Gew.-%, bevorzugt 40 bis 90 Gew.-%, besonders bevorzugt 45 bis 85 Gew.-%, ganz besonders bevorzugt 50 bis 80 Gew.-%, eines Copolymers eines oder mehrerer Monomere als Pfropfgrundlage, erhalten durch Copolymerisation eines Monomeren-Gemisches, umfassend:
   (b11): 70 bis 99,99 Gew.-% mindestens eines konjugierten Diens und/oder mindestens eines Acrylats,
   (b12): 0 bis 29 Gew.-% mindestens eines weiteren Comonomers ausgewählt aus: Styrol, α-Methylstyrol, Acrylnitril, Methacrylnitril, und Methylmethacrylat,
   (b13): 0 bis 10 Gew.-% eines oder mehrerer polyfunktioneller, vernetzender Monomere, und
   (b14): 0,01 bis 0,7 Gew.-% eines Kettenübertragungs-Reagenzes,
   bezogen auf die gesamte Monomer-Menge des Polymerisationsgemischs zur Herstellung des Copolymers (b1);
(b2): 10 bis 80 Gew.-%, bevorzugt 10 bis 60 Gew.-%, besonders bevorzugt 15 bis 55 Gew.-%, ganz besonders bevorzugt 20 bis 50 Gew.-%, einer Pfropfauflage eines oder mehrerer Monomere, bestehend aus:
   (b21): 65 bis 95 Gew.-%, bevorzugt 70 bis 90 Gew.-%, besonders bevorzugt 75 bis 85 Gew.-% mindestens eines vinylaromatischen Monomeren, vorzugsweise Styrol und/oder α-Methylstyrol, insbesondere Styrol,
   (b22): 5 bis 35 Gew.-%, bevorzugt 10 bis 30 Gew.-%, besonders bevorzugt 15 bis 25 Gew.-% Acrylnitril und/oder Methacrylnitril, vorzugsweise Acrylnitril, und
   (b23): 0 bis 30 Gew.-%, bevorzugt 0 bis 20 Gew.-%, besonders bevorzugt 0 bis 15 Gew.-% mindestens eines weiteren monoethylenisch ungesättigten Monomeren ausgewählt aus: MMA, MSA und N-PMI, vorzugsweise MMA,
   bezogen auf die gesamte Monomer-Menge des Polymerisationsgemischs zur Herstellung der Pfropfauflage (b2).

Als konjugierte Diene (b11) kommen Diene mit 4 bis 8 Kohlenstoffatomen wie Butadien, Isopren, Piperylen und Chloropren oder deren Mischungen in Betracht. Bevorzugt verwendet man Butadien oder Isopren oder deren Mischungen, ganz besonders bevorzugt Butadien.

Copolymere (b1) auf Grundlage von konjugierten Dienen (b11) sind beispielsweise Copolymere der vorgenannten konjugierten Diene (b11) untereinander, Copolymere solcher Diene mit Acrylaten (b11), insbesondere n-Butylacrylat, und Copolymere solcher Diene mit den Comonomeren (b12) ausgewählt aus Styrol, α-Methylstyrol, Acrylnitril, Methacrylnitril und Methylmethacrylat, die in Gegenwart eines Kettenübertragungs-Reagenzes (b14) in der angegebenen Menge hergestellt wurden.

Die Dien-Polymere können auch zusätzliche vernetzend wirkende, polyfunktionelle Monomere (b13) enthalten. Beispiele hierfür sind Monomere, die zwei oder mehr zur Copolymerisation befähigte Doppelbindungen enthalten wie Ethylenglykoldiacrylat, Butandioldiacrylat, Hexandioldiacrylat, Ethylenglykoldimethacrylat, Butandioldimethacrylat, Hexandioldimethacrylat, Divinylbenzol, Diallylmaleat, Diallylfumarat, Diallylphthalat, Diallylcyanurat, Tris-allyl-cyanurat, Ester des Tricyclodecenylalkohols wie Tricyclodecenylacrylat, Dihydrodicyclopentadienylacrylat, Diallylphosphat, Allylacrylat, Allylmethacrylat und Dicyclopentadienylacrylat (DCPA). Bevorzugt werden Ester des Tricyclodecenylalkohols, Divinylbenzol, Allyl(meth)acrylat und/oder Tris-allyl-cyanurat eingesetzt. Bevorzugte Dien-Polymere sind handelsübliche Butadien-, Butadien-Styrol-, Butadien-Methylmethacrylat-, Butadien-n-Butylacrylat-, Butadien-Acrylnitril- und Acrylnitril-Butadien-Styrol-Copolymere (ABS); besonders bevorzugt sind ABS-Copolymere.

Derartige bevorzugte Dien-Copolymere (b1) und ABS-Schlagzähmodifikatoren (b) werden in der EP 0 993 476 beschrieben.

Bei den Copolymeren (b1) auf Grundlage von Acrylaten handelt es sich im Allgemeinen um Alkylacrylat-Polymere aus einem oder mehreren C4-C8-Alkylacrylaten, wobei bevorzugt mindestens teilweise Butyl-, Hexyl-, Octyl- oder 2-Ethylhexylacrylat verwendet werden. Diese Alkylacrylat-Polymere können bis zu 29 Gew.-% harte Polymere bildende Monomere wie Styrol, α-Methylstyrol, Acrylnitril, Methacrylnitril und Methylmethacrylat einpolymerisiert enthalten.

Bei den vorgenannten Schlagzähmodifikatoren (b) handelt es sich vorzugsweise um Acrylnitril-Butadien-Styrol-(ABS)- und/oder Acrylnitril-Styrol-Acrylat-(ASA)-Copolymere.

Eine bevorzugt Ausführungsform sind Acrylnitril-Styrol-Acrylat-Copolymere (ASA). Die Acrylat-Copolymere enthalten weiterhin bis zu 10 Gew.-%, vorzugsweise 1 bis 5 Gew.-% an vernetzend wirkenden, polyfunktionellen Monomeren (b13) (Vernetzungsmonomere). Beispiele hierfür sind Monomere, die zwei oder mehr zur Copolymerisation befähigte Doppelbindungen enthalten wie Ethylenglykoldiacrylat, Butandioldiacrylat, Hexandioldiacrylat, Ethylenglykoldimethacrylat, Butandioldimethacrylat, Hexandioldimethacrylat, Divinylbenzol, Diallylmaleat, Diallylfumarat, Diallylphthalat, Diallylcyanurat, Tris-allyl-cyanurat, Ester des Tricyclodecenylalkohols wie Tricyclodecenylacrylat, Dihydrodicyclopentadienylacrylat, Diallylphosphat, Allylacrylat, Allylmethacrylat und Dicyclopentadienylacrylat (DCPA). Bevorzugt werden Ester des Tricyclodecenylalkohols, Divinylbenzol, Allyl(meth)acrylat und/oder Tris-allyl-cyanurat eingesetzt.

Der erfindungsgemäß hergestellte Schlagzähmodifikator (b) ist besonders bevorzugt ein ABS-Schlagzähmodifikator (b) mit
(b1): 40 bis 90 Gew.-%, bezogen auf den Schlagzähmodifikator (b), einer Pfropfgrundlage bestehend aus:
   (b11): 70 bis 99,99 Gew.-%, bevorzugt 90 bis 99,89 Gew.-% Butadien,
   (b12): 0 bis 29 Gew.-%, bevorzugt 1 bis 10 Gew.-%, Styrol, und
   (b14): 0,01 bis 0,7 Gew.-% eines Kettenübertragungs-Reagenzes,
   bezogen auf die gesamte Monomer-Menge des Polymerisationsgemischs zur Herstellung des Copolymers (b1); und
(b2): 10 bis 60 Gew.-%, bezogen auf den Schlagzähmodifikator (b), einer Pfropfauflage bestehend aus:
   (b21): 65 bis 95 Gew.-% Styrol,
   (b22): 5 bis 35 Gew.-% Acrylnitril, und
   (b23): 0 bis 30 Gew.-% MMA,
   bezogen auf die gesamte Monomer-Menge des Polymerisationsgemischs zur Herstellung der Pfropfauflage (b2).

Bei der Weichkomponente handelt es sich bevorzugt um ein mehrstufig aufgebautes Copolymer (sog. "Kern/Schale-Aufbau", "core/shell morphology"). Beispielsweise kann ein kautschukelastischer Kern (Glasübergangstemperatur TG <50°C) von einer "harten" Schale (Polymere mit TG >50°C) oder umgekehrt umhüllt sein. Derartige Kern-Schale-Pfropfcopolymere sind bekannt.

### Verfahren zur Herstellung der Schlagzähmodifikatoren (b)

Verfahren zur Herstellung der Schlagzähmodifikatoren (b) sind dem Fachmann prinzipiell bekannt und in der Literatur beschrieben. Entsprechende Produkte sind zum Teil kommerziell erhältlich. Als besonders vorteilhaft hat sich die Herstellung durch Emulsionspolymerisation erwiesen (DE-C 12 60 135 und EP 0 993 476 B1). Allgemein umfasst die Herstellung der Schlagzähmodifikatoren (b) die Herstellung eines Copolymers (b1) als Pfropfgrundlage und die Herstellung einer Pfropfauflage (b2).

### Herstellung des Copolymers (b1)

Üblicherweise polymerisiert man bei 20 bis 100°C, bevorzugt 30 bis 80°C. In der Regel werden übliche Emulgatoren mitverwendet, beispielsweise Alkalimetallsalze von Alkyl- oder Alkylarylsulfonsäuren, Alkylsulfate, Fettalkoholsulfonate, Salze höherer Fettsäuren mit 10 bis 30 Kohlenstoffatomen, Sulfosuccinate, Ethersulfonate oder Harzseifen. Vorzugsweise nimmt man die Alkalimetallsalze, insbesondere die Na- und K-Salze, von Alkylsulfonaten oder Fettsäuren mit 10 bis 18 Kohlenstoffatomen.

In der Regel werden die Emulgatoren in Mengen von 0,5 bis 5 Gew.-%, insbesondere von 0,5 bis 3 Gew.-%, bezogen auf die bei der Herstellung des Copolymers (b1) eingesetzten Monomere, eingesetzt.

Vorzugsweise verwendet man zur Herstellung der Dispersion so viel Wasser, dass die fertige Dispersion einen Feststoffgehalt von 20 bis 50 Gew.-% hat. Üblicherweise wird bei einem Wasser/Monomeren-Verhältnis von 2:1 bis 0,7:1 gearbeitet.

Zum Starten der Polymerisationsreaktion sind alle Radikalbildner geeignet, die bei der gewählten Reaktionstemperatur zerfallen, also sowohl solche, die allein thermisch zerfallen, als auch solche, die dies in Gegenwart eines Redox-Systems tun. Als Polymerisationsinitiatoren kommen vorzugsweise Radikalbildner, beispielsweise Peroxide wie bevorzugt Peroxosulfate (etwa Natrium- oder Kaliumpersulfat) und Azoverbindungen wie Azodiisobutyronitril in Betracht. Es können jedoch auch Redox-Systeme, insbesondere solche auf Basis von Hydroperoxiden wie Cumolhydroperoxid, eingesetzt werden.

In der Regel werden die Polymerisationsinitiatoren in einer Menge von 0,1 bis 1 Gew.-%, bezogen auf die Pfropfgrundlage-Monomeren (b11) und (b12), eingesetzt. Bevorzugt werden die Polymerisationsinitiatoren in einer Menge von 0,1 bis 0,5 Gew.-% bezogen auf die gesamte Monomer-Menge des Polymerisationsgemischs, insbesondere in einer Menge von 0,2 bis 0,4 Gew.-% bezogen auf die gesamte Monomer-Menge des Polymerisationsgemischs zu Herstellung des Copolymers (b1) eingesetzt.

Die Radikalbildner und auch die Emulgatoren werden dem Reaktionsansatz beispielsweise diskontinuierlich als Gesamtmenge zu Beginn der Reaktion, oder aufgeteilt in mehrere Portionen absatzweise zu Beginn und zu einem oder mehreren späteren Zeitpunkten zugefügt, oder kontinuierlich während eines bestimmten Zeitintervalls zugefügt.

Die kontinuierliche Zugabe kann auch entlang eines Gradienten erfolgen, der z. B. auf- oder absteigend, linear oder exponentiell, oder auch stufenweise (Treppenfunktion) sein kann.

Kettenübertragungs-Reagenzien werden in einer Konzentration von weniger als 0,75 Gew.-%, insbesondere weniger als 0,7 Gew.-% bezogen auf die gesamte eingesetzte Monomer-Menge eingesetzt. Bevorzug werden die Kettenübertragungs-Reagenzien in einem Mengenbereich von 0,01 bis 0,7 Gew.-%, bevorzugt in einem Bereich von 0,1 bis 0,6 Gew.-%, insbesondere in einem Bereich von 0,2 bis 0,6 Gew.-%, bezogen auf die gesamte Monomer-Menge, welche zur Herstellung des Copolymers (b1) eingesetzt wird. Besonders bevorzugt ist eine Zugabe in einem Mengenbereich von 0,3 bis 0,6 Gew.-%, insbesondere 0,4 bis 0,55 Gew.-%, bezogen auf die gesamte Monomer-Menge.

Geeignete Kettenübertragungs-Reagenzien sind z. B. Mercaptane, Phosphinate, Bisulfite, Terpinole und dimeres α-Methylstyrol, insbesondere Mercaptomethanol, Ethylhexylthioglycolat, n-Dodecylmercaptan, t-Dodecylmercaptan, Mercaptopropionsäure, Bis-(isopropylxanthogen)disulfit, Natriumhypophosphit (NHP) und Gemische davon.

Besonders bevorzugt wird t-Dodecylmercaptan als Kettenübertragungs-Reagenz in einem Mengenbereich von 0,01 bis 0,7 Gew.-%, bevorzugt in einem Bereich von 0,1 bis 0,6 Gew.-%, insbesondere in einem Bereich von 0,2 bis 0,6 Gew.-%, bezogen auf die gesamte Monomer-Menge, welche zur Herstellung des Copolymers (b1) eingesetzt wird, verwendet. Besonders bevorzugt ist eine Zugabe von t-Dodecylmercaptan in einem Mengenbereich von 0,3 bis 0,6 Gew.-%, insbesondere 0,4 bis 0,55 Gew.-%, bezogen auf die gesamte Monomer-Menge.

Ferner können zusätzliche polyfunktionelle, vernetzende Monomere als Vernetzungsmittel in einer Menge von 0 bis 10 Gew.-% zugegeben werden.

Geeignete Vernetzungsmittel sind z.B. Ethylenglykoldiacrylat, Butandioldiacrylat, Hexandioldiacrylat, Ethylenglykoldimethacrylat, Butandioldimethacrylat, Hexandioldimethacrylat, Divinylbenzol, Diallylmaleat, Diallylfumarat, Diallylphthalat, Diallylcyanurat, Tris-allyl-cyanurat, Ester des Tricyclodecenylalkohols wie Tricyclodecenylacrylat, Dihydrodicyclopentadienylacrylat, Diallylphosphat, Allylacrylat, Allylmethacrylat und Dicyclopentadienylacrylat (DCPA) sowie Gemische aus den Genannten. Bevorzugt werden Ester des Tricyclodecenylalkohols, Divinylbenzol, Allyl(meth)acrylat und/oder Tris-allyl-cyanurat eingesetzt.

Die Kettenübertragungs-Reagenzien und Vernetzungsmittel werden dem Reaktionsansatz diskontinuierlich oder kontinuierlich zugefügt, wie dies für die Radikalbildner und Emulgatoren zuvor beschrieben wurde. Bevorzugt wird die Zugabemenge und der Zugabezeitpunkt an Molekulargewichtsreglern in Abhängigkeit des gewünschten Vernetzungsgrades der Polymerisation gewählt. Die Zugabe erfolgt bevorzugt diskontinuierlich. Beispielsweise erfolgt die Zugabe in 1 bis 7 Schritten, bevorzugt in 2 bis 5 Schritten insbesondere in 3 bis 4 Schritten.

Der Zugabe-Zeitpunkt ist prinzipiell frei wählbar. Bevorzugt findet die erste Zugabe von Kettenübertragungs-Reagenzien bzw. Vernetzungsmitteln statt, nachdem etwa 10 bis 20% der gesamten Reaktionszeit seit Beginn der Polymerisation abgelaufen sind, insbesondere nachdem etwa 12 bis 16% der Reaktionszeit verstrichen sind, besonders bevorzugt nachdem etwa 13 bis 14% der Reaktionszeit verstrichen sind.

Bevorzugt findet die zweite Zugabe von Kettenübertragungs-Reagenzien bzw. Vernetzungsmitteln statt, nachdem etwa 45 bis 55% der gesamten Reaktionszeit seit Beginn der Polymerisation abgelaufen sind, insbesondere nachdem etwa 49 bis 53% der Reaktionszeit verstrichen sind, besonders bevorzugt nachdem etwa 50 bis 52% der Reaktionszeit verstrichen sind. Bevorzugt findet die dritte Zugabe von Kettenübertragungs-Reagenzien bzw. Vernetzungsmitteln statt, nachdem etwa 90 bis 100% der gesamten Reaktionszeit seit Beginn der Polymerisation abgelaufen sind, insbesondere nachdem etwa 95 bis 99,5% der Reaktionszeit verstrichen sind, besonders bevorzugt nachdem etwa 97 bis 99% der Reaktionszeit verstrichen sind.

Die Polymerisationsdauer beträgt 1 Minute bis 20 Stunden, insbesondere 1 Stunde bis 16 Stunden, bevorzugt 4 Stunden bis 12 Stunden.

Bei einer beispielhaften Gesamtreaktionszeit von 8,5 Stunden ergibt sich daraus beispielsweise folgendes Zugabeschema: Bevorzugt findet die erste Zugabe von Kettenübertragungs-Reagenzien bzw. Vernetzungsmitteln 50 bis 90 Minuten nach Beginn der Polymerisation statt, insbesondere nach 60 bis 80 Minuten, besonders bevorzugt nach 65 bis 75 Minuten. Bevorzugt findet die zweite Zugabe von Kettenübertragungs-Reagenzien bzw. Vernetzungsmitteln 240 bis 280 Minuten nach Beginn der Polymerisation statt, insbesondere nach 250 bis 270 Minuten, besonders bevorzugt nach 255 bis 265 Minuten. Bevorzugt findet die dritte Zugabe von Kettenübertragungs-Reagenzien bzw. Vernetzungsmitteln 480 bis 510 Minuten nach Beginn der Polymerisation statt, insbesondere nach 490 bis 510 Minuten, besonders bevorzugt nach 495 bis 505 Minuten.

Die zugegebene Menge an Kettenübertragungs-Reagenz bzw. Vernetzungsmittel kann in jedem Zugabeschritt gleich sein und einem gleichmäßigen Anteil der gesamten zugegebenen Menge entsprechen. Bevorzugt wird im ersten Zugabeschritt jedoch mehr Kettenübertragungs-Reagenz bzw. Vernetzungsmittel zugegeben als im letzten Zugabeschritt. Beispielsweise werden bei einem Zugabeschema aus drei Zugabeschritten im ersten und im zweiten Zugabeschritt jeweils etwa 35 bis 45 Gew.-% der Gesamtmenge an Kettenübertragungs-Reagenz bzw. Vernetzungsmittel zugegeben, während im dritten Zugabeschritt etwa 10 bis 30 Gew.-% der Gesamtmenge an Kettenübertragungs-Reagenz bzw. Vernetzungsmittel zugegeben werden.

Zur Einhaltung eines konstant bleibenden pH-Wertes, der vorzugsweise bei 6 bis 9 liegt, kann man Puffersubstanzen wie Na₂HPO₄/NaH₂PO₄, Natriumhydrogencarbonat oder Puffer auf Basis von Citronensäure/Citrat, mitverwenden. Regler und Puffersubstanzen werden in den üblichen Mengen eingesetzt, so dass sich nähere Angaben hierzu erübrigen.

Man kann das Copolymer (b1) in einer besonderen Ausführungsform auch durch Polymerisation der Monomeren (b11) bis (b13) in Gegenwart des Kettenübertragungs-Reagenzes (b14) und eines feinteiligen Latex herstellen (sog. "Saatlatex-Fahrweise" der Polymerisation).

Dieser Latex wird vorgelegt und kann aus kautschukelastische Polymere bildenden Monomeren, oder auch aus anderen Monomeren, wie sie bereits genannt wurden, bestehen. Geeignete Saatlatices bestehen beispielsweise aus Polybutadien oder Polystyrol. Besonders bevorzugt sind Saatlatices aus Polystyrol.

In einer anderen bevorzugten Ausführungsform kann man das Copolymer (b1) im sogenannten Zulaufverfahren herstellen. Bei diesem Verfahren wird ein bestimmter Anteil der Monomeren (b11) bis (b13) und des Kettenübertragungs-Reagenzes (b14) vorgelegt und die Polymerisation gestartet, wonach man den Rest der Monomeren (b11) bis (b13) und ggf. des Kettenübertragungs-Reagenzes (b14) ("Zulaufanteil") als Zulauf während der Polymerisation zufügt.

Die Zulaufparameter (Gestalt des Gradienten, Menge, Dauer, etc.) hängen von den anderen Polymerisationsbedingungen ab. Sinngemäß gelten auch hier die zur Zugabeweise des Radikalstartes bzw. Emulgators gemachten Ausführungen. Bevorzugt beträgt beim Zulaufverfahren der vorgelegte Anteil der Monomeren zur Herstellung von (b1) 5 bis 50, besonders bevorzugt 8 bis 40 Gew.-%, bezogen auf (b1). Bevorzugt lässt man den Zulaufanteil von (b11) bis (b13) innerhalb 1 bis 18 Stunden, insbesondere 2 bis 16 Stunden, ganz besonders 4 bis 12 Stunden, zulaufen.

Die genauen Polymerisationsbedingungen, insbesondere Art, Menge und Dosierung des Emulgators und der anderen Polymerisationshilfsstoffe werden bevorzugt so gewählt, dass der erhaltene Latex des Schlagzähmodifikators (b), eine mittlere Teilchengröße, definiert durch den d50-Wert der Teilchengrößenverteilung, von 80 bis 1000 nm, bevorzugt 85 bis 600 nm und besonders bevorzugt 90 bis 500 nm aufweist.

Üblicherweise wird die Polymerisation des Copolymers (b1) durch Wahl der Reaktionsbedingungen so geführt, dass eine Pfropfgrundlage mit einem bestimmten Vernetzungszustand resultiert. Als hierfür wesentliche Parameter sind die Reaktionstemperatur und -dauer, das Verhältnis von Monomeren, Regler, Radikalstarter und beispielsweise beim Zulaufverfahren, die Zulaufgeschwindigkeit und die Menge und der Zugabezeitpunkt von Regler und Initiator anzuführen. Zur genauen Vorgehensweise wird auf die nachfolgende Beschreibung des Verfahrens zur Optimierung des Vernetzungsgrades verwiesen.

Die Reaktionsbedingungen können so aufeinander abgestimmt werden, dass die Polymerteilchen eine bi-modale Teilchengrößenverteilung aufweisen, also eine Größenverteilung mit zwei mehr oder weniger ausgeprägten Maxima. Das erste Maximum ist deutlicher ausgeprägt (vergleichsweise schmaler Peak) als das zweite und liegt in der Regel bei 25 bis 200 nm, bevorzugt 60 bis 170 nm, besonders bevorzugt 70 bis 150 nm. Das zweite Maximum ist vergleichsweise breit und liegt in der Regel bei 150 bis 800 nm, bevorzugt 180 bis 700 nm, besonders bevorzugt 200 bis 600 nm. Dabei liegt das zweite Maximum (150 bis 800 nm) bei größeren Teilchengrößen als das erste Maximum (25 bis 200 nm).

Bevorzugt wird die bi-modale Teilchengrößenverteilung durch eine (teilweise) Agglomeration der Polymerteilchen erzielt. Dazu kann beispielsweise wie folgt vorgegangen werden: Man polymerisiert die Monomeren (b11) bis (b13) in Gegenwart des Kettenübertragungs-Reagenzes (b14), welche den Kern aufbauen, bis zu einem Umsatz von üblicherweise mindestens 90%, bevorzugt grösser 95%, bezogen auf die eingesetzten Monomeren. Dieser Umsatz ist in der Regel nach 4 bis 20 Stunden erreicht. Der erhaltene Polymerlatex hat eine mittlere Teilchengrösse d50 von maximal 200 nm und eine enge Teilchengrössenverteilung (nahezu monodisperses System).

In der zweiten Stufe wird der Polymerlatex agglomeriert. Dies geschieht in der Regel durch Zugabe einer Dispersion eines Acrylesterpolymers. Vorzugsweise werden Dispersionen von Copolymeren von (C1-C4-Alkyl)estern der Acrylsäure, vorzugsweise von Ethylacrylat, mit 0,1 bis 10 Gew.-% polare Polymere bildenden Monomeren, wie z.B. Acrylsäure, Methacrylsäure, Acrylamid, Methacrylamid, N-Methylolmethacrylamid oder N-Vinylpyrrolidon, eingesetzt. Besonders bevorzugt ist ein Copolymer aus 96% Ethylacrylat und 4% Methacrylamid. Die Agglomerierdispersion kann gegebenenfalls auch mehrere der genannten Acrylesterpolymere enthalten.

Die Konzentration der Acrylester-polymere in der zur Agglomeration verwendeten Dispersion soll im Allgemeinen zwischen 3 und 40 Gew.-% liegen.

Bei der Agglomeration werden 0,2 bis 20, vorzugsweise 1 bis 5 Gew.-Teile der Agglomerierdispersion auf 100 Teile des Polymerlatex, jeweils berechnet auf Feststoffe, eingesetzt. Die Agglomeration wird durch Zugabe der Agglomerier-Dispersion zum Polymer durchgeführt. Die Geschwindigkeit der Zugabe ist normalerweise nicht kritisch, im Allgemeinen dauert sie etwa 1 bis 30 Minuten bei einer Temperatur zwischen 20 und 90°C, vorzugsweise zwischen 30 und 75°C.

Außer mittels einer Acrylesterpolymer-Dispersion kann der Polymerlatex auch durch andere Agglomerier-Mittel wie z. B. Essigsäureanhydrid, agglomeriert werden. Auch eine Agglomeration durch Druck oder Einfrieren (Druck- bzw. Gefrieragglomeration) ist möglich. Die genannten Methoden sind dem Fachmann bekannt.

Unter den genannten Bedingungen wird nur ein Teil der Polymerteilchen agglomeriert, so dass eine bimodale Verteilung entsteht. Dabei liegen nach der Agglomeration im Allgemeinen mehr als 50%, vorzugsweise zwischen 75% und 95% der Teilchen (Zahlen-Verteilung) im nicht agglomerierten Zustand vor. Der erhaltene teilagglomerierte Polymerlatex ist verhältnismäßig stabil, so dass er ohne weiteres gelagert und transportiert werden kann, ohne dass Koagulation eintritt.

Um eine bimodale Teilchengrössenverteilung des Schlagzähmodifikators (b) zu erzielen, ist es auch möglich, zwei verschiedene Schlagzähmodifikatoren (b) und (b*), die sich in ihrer mittleren Teilchengröße unterscheiden, getrennt voneinander in üblicher Weise herzustellen und die Schalgzähmodifikatoren (b) und (b*) im gewünschten Mengenverhältnis zusammenzugeben.

### Herstellung der Pfropfauflage (b2)

Die Herstellung der Pfropfauflage (b2) kann unter den gleichen Bedingungen wie die Herstellung des Copolymers (b1) erfolgen, wobei man die Auflage (b2) in einem oder mehreren Verfahrensschritten herstellen kann. Beispielsweise kann man bei einer zweistufigen Pfropfung zunächst z.B. Styrol alleine und danach Styrol und Acrylnitril in zwei aufeinanderfolgenden Schritten polymerisieren.

Diese zweistufige Pfropfung (zunächst Styrol, dann Styrol/Acrylnitril) ist eine bevorzugte Ausführungsform. Weitere Einzelheiten zur Herstellung der Pfropfcopolymeren bzw. der Schlagzähmodifikatoren (b), sind in den DE-OS 12 60 135 und 31 49 358 beschrieben.

Es ist vorteilhaft, die Pfropfpolymerisation auf dem Copolymer (b1) als Pfropfgrundlage wiederum in wässriger Emulsion durchzuführen. Sie kann im gleichen System wie die Polymerisation der Pfropfgrundlage vorgenommen werden, wobei weiter Emulgator und Initiator zugegeben werden kann. Diese müssen mit den zur Herstellung des Co-polymers (b1) verwendeten Emulgatoren bzw. Initiatoren nicht identisch sein. So kann z. B. zweckmässig sein, als Initiator für die Herstellung des Copolymers (b1) ein Persulfat zu verwenden, zur Polymerisation der Pfropfauflage (b2) jedoch ein Redoxinitiator-System einzusetzen. Im Übrigen gilt für die Wahl von Emulgator, Initiator und Polymerisationshilfsstoffen das bei der Herstellung des Copolymers (b1) gesagte. Das aufzupfropfende Monomerengemisch kann dem Reaktionsgemisch auf einmal, absatzweise in mehreren Stufen oder vorzugsweise kontinuierlich während der Polymerisation zugegeben werden.

In einer besonders bevorzugten Ausführungsform fügt man während der Pfropfung des Copolymers (b1) als Pfropfgrundlage mit den Monomeren (b21) bis (b23) ein Reduktionsmittel zu.

Soweit bei der Pfropfung des Copolymers (b1) nicht gepfropfte Polymere aus den Monomeren (b21) bis (b23) entstehen, werden die Mengen, die in der Regel unter 10 Gew.-% von (b2) liegen, der Masse des Schlagzähmodifikators (b) zugeordnet.

Gemäß einer weiteren bevorzugten Ausführungsform kann der Schlagzähmodifikator (b) durch Massepolymerisation wie beispielsweise in "Modern Styrenic Polymers: Polystyrenes and Styrenic Copolymers" (Eds., J. Scheirs, D. Priddy, Wiley, Chichester, UK, (2003), Seiten 29 und 305 ff) beschrieben hergestellt werden.

### Verfahren zur Optimierung des Vernetzungsgrades

Das erfindungsgemäße Verfahren zur Optimierung des Vernetzungsgrades (V) eines vernetzten Copolymers (b1) als Pfropfgrundlage für einen polymeren Schlagzähmodifikator (b) umfasst die folgenden Schritte:
(i) Polymerisieren des Monomeren-Gemisches zur Herstellung des Copolymers (b1);
(ii) Bestimmen des Vernetzungsgrades (V) des in Schritt (i) erhaltenen Copolymers (b1) mittels NMR-Relaxationsmessungen;
(iii) Polymerisieren eines modifizierten Monomeren-Gemisches zur Herstellung eines modifizierten Copolymers (b1'), wobei die Parameter der Polymerisations-Reaktion in Abhängigkeit des gemäß Schritt (ii) ermittelten Vernetzungsgrads (V) des Copolymers (b1) und des gewünschten Vernetzungsgrads (V') des Copolymers (b1') als Pfropfgrundlage angepasst werden;
(iv) gegebenenfalls Wiederholen der Schritte (i) bis (iii), bis ein gewünschter Vernetzungsgrad (V') erreicht wird.

Bezüglich des Schlagzähmodifikators (b), des Copolymers (b1) und der Pfropfauflage (b2) gelten die zuvor gemachten Ausführungen.

Gemäß Schritt (i) des Verfahrens wird das Copolymer (b1) durch Polymerisation eines definierten Monomeren-Gemisches hergestellt. Alle zuvor gemachten Ausführungen zu diesem Polymerisationsschritt, der Auswahl und Menge der Monomere sowie sonstige getroffene Angaben gelten entsprechend.

Schritt (ii) des Verfahrens betrifft die Bestimmung des Vernetzungsgrades des in Schritt (i) erhaltenen Copolymers (b1) mittels NMR-Relaxationsmessungen.

Die Kernspin-Relaxation wird durch die longitudinale Relaxationszeit (Spin-Gitter-Relaxationszeit) T1 beschrieben, die die Rückkehr eines angeregten Kernspinsystems ins thermische Gleichgewicht charakterisiert und durch die transversale Relaxationszeit (Spin-Spin-Relaxationszeit) T2, die beschreibt, wie lange nach einer NMR-Anregung ein Signal detektiert werden kann.

Beide Relaxationszeiten hängen in einer charakteristischen Weise von der lokalen Beweglichkeit der molekularen Umgebung der Kernspins ab, die mittels einer Korrelationszeit τ beschrieben werden kann. Die Abhängigkeit der transversalen Relaxationszeit von der molekularen Beweglichkeit ist monoton, sodass sie damit als eine Art qualitatives Rheometer aufgefasst werden kann. Daher ist die Verwendung der transversalen Relaxationszeit T2 bevorzugt.

Je stärker vernetzt ein bestimmtes Netzwerk ist, desto niedriger liegen seine T2-Zeiten. Übliche T2-Zeiten für die erfindungsgemäßen Pfropfgrundlagen (b1) sind T2-Zeiten im Bereich 2,0 bis 7 ms, bevorzugt 2,5 bis 6,0 ms und besonders bevorzugt 3,0 bis 5,5 ms, gemessen an verfilmten Proben bei 140°C.

Die Messung der transversalen Relaxationszeiten T2 kann mittels NMR-Spektrometern durchgeführt werden. Es können Geräte mit Feldstärken von 0,001 bis 15 Tesla verwendet werden. Bevorzugt sind NMR-Geräte im Niederfeld-Bereich mit Feldstärken von 0,001 bis 1,5 Tesla, insbesondere 0,1 bis 0,6 Tesla. Diese Geräte sind klein, robust und kostengünstig. Analytisch relevante Informationen können aus den Kernspin-Relaxationszeiten sowie aus den zugehörigen Signal-Amplituden gewonnen werden. Da die Bestimmung der Relaxationszeiten durch die Analyse der NMR-Signale in der Zeitdomäne anstatt wie bei der NMR-Spektroskopie in der Frequenzdomäne erfolgt, spricht man auch von Time-Domain NMR (TD-NMR).

Zur Messung der Relaxationszeit können Proben des Copolymers (b1), Proben des Schlagzähmodifikators (b), oder Proben der Polymerzusammensetzung (A) untersucht werden. Bevorzugt wird der Vernetzungsgrad anhand des Schlagzähmodifikators (b) oder der Polymerzusammensetzung (A), insbesondere anhand des Schlagzähmodifikators (b) bestimmt.

Die Bestimmung der T2-Zeit geschieht durch Messen der NMR-Relaxation einer entwässerten und verfilmten Probe oder einer Probe in Form einer flüssigen Polymerdispersion. Zur Messung einer verfilmten Probe wird beispielsweise die Probe nach Ablüften über Nacht bei z.B. 80°C 3 h im Vakuum getrocknet und dann mit einem geeigneten Messgerät, z. B. minispec-Gerät der Fa. Bruker, bei 20°C bis 150°C, bevorzugt bei 30°C bis 140°C vermessen.

Die Probe kann auch ohne weitere Probenvorbereitung direkt dem Reaktionsgemisch entnommen werden und als flüssige Polymerdispersion vermessen werden.

Hierzu kann die sogenannte Solid-Echo-Carr-Purcell-Meiboom-Gill-Sequenz (SE-CPMG) genutzt werden. Nähere Informationen zu dieser Methode können beispielsweise gefunden werden in: N. Nestle, K. Häberle, Analytica Chimica Acta 654 (2009) 35-39. SE-CPMG ist eine Methode, in der Puls-NMR zur Bestimmung der Spin-Spin-Relaxationszeit T2 verwendet wird. Bei dieser Methode werden in relativ kurzen Abständen Spin-Echos erzeugt. Bevorzugt sind Zeitabstände von 80 µs bis 200 µs. Vorteile dieses Vorgehens sind zum einen die Schnelligkeit, da der ganze transversale Magnetisierungsabfall mit einem einzelnen Anregungsvorgang ausgelesen wird, und zum anderen die relativ geringe Empfindlichkeit gegen Diffusionseffekte in flüssiger Phase. Bei der CPMG-Methode hängt der diffusionsbedingte Fehler nur linear von der Zeit ab und kann durch kurze Pulsabstände sehr klein gehalten werden. SE-CPMG-Experimente werden bevorzugt an flüssigen Polymerdispersionen der Pfropfgrundlage (b1) und bei 20°C bis 50°C, insbesondere bei 25°C bis 40°C durchgeführt.

Verfilmte Proben können mittels dem Fachmann bekannter Hahn-Echo-Experimente und Festkörper-Echo-Experimente untersucht werden. Das Hahn-Echo-Experiment (oder Spin-Echo-Experiment) wird mit der Impulsfolge 90° - τ -180° - τ - Echo durchgeführt, wobei τ das Zeitintervall zwischen den Pulsen ist. Beim Festkörper-Echo-Experiment wird durch eine Folge von zwei senkrecht zueinander orientierten 90°-Pulsen ein Echo erzeugt, wodurch der Einfluss der gegenseitigen magnetischen Dipol-Dipol-Wechselwirkung der Kerne in einem Festkörper refokussiert wird. Die NMR-Messungen an verfilmten Proben werden bei 20°C bis 150°C, bevorzugt bei 30°C bis 140°C durchgeführt.

Vergleichbar sind nur Proben, die nach der gleichen Methode vermessen und vorbereitet wurden, da die Relaxation deutlich von den Messbedingungen, wie z.B. der Temperatur, und der Art der Probenvorbereitung abhängig ist.

Zur Bestimmung des Vernetzungsgrades (V) des Copolymers (b1) sind Messungen der transversale Relaxationszeiten T2 bevorzugt.

Die Messungen werden insbesondere mittels Niederfeld-NMR-Spektroskopie bei Feldstärken von 0,001 bis 1,5 Tesla durchgeführt. Besonders bevorzugt sind Feldstärken von 0,1 bis 0,6 Tesla.

Diese können sowohl an flüssigen Polymerdispersionen als auch an festen Polymerproben, z.B. in Form von Polymerfilmen, durchgeführt werden. Bei der Vermessung von Polymerdispersionen ist als Messverfahren insbesondere das SE-CPMG-Verfahren bevorzugt. Polymerfilme werden bevorzug mit einem Hahn-Echo- oder Festkörper-Echo-Experiment untersucht.

Gemäß dem erfindungsgemäßen Verfahren wird der Vernetzungsgrad (V) des Copolymers (b1) ermittelt, um so die Reaktionsbedingungen der Polymerisationsreaktion zur Herstellung des Copolymers (b1) an den gewünschten Vernetzungsgrad anzupassen. Dies geschieht in der Form, dass in Schritt (iii) des Verfahrens ein modifizierten Monomeren-Gemisch zur Herstellung eines modifizierten Copolymers (b1') polymerisiert wird. Dieses modifizierte Monomeren-Gemisch unterscheidet sich dadurch von dem ersten Monomeren-Gemisch, dass die Zusammensetzung variiert wird. Insbesondere werden die Mengen an zusätzlichem vernetzendem Monomer (b13) und an Kettenübertragungs-Reagenz (b14) variiert.

Ferner werden die Parameter der Polymerisations-Reaktion in Abhängigkeit des gemäß Schritt (ii) ermittelten Vernetzungsgrads (V) des Copolymers (b1) und des gewünschten Vernetzungsgrads (V') des Copolymers (b1') als Pfropfgrundlage angepasst. Dies kann geschehen durch Veränderung der Reaktionstemperatur und -dauer, des Verhältnisses von Monomeren, Regler und Radikalstarter und beispielsweise beim Zulaufverfahren durch Veränderung von Zulaufgeschwindigkeit, Menge und Zugabe-zeitpunkt von Regler und Initiator. Insbesondere wird die Reaktion durch die Zugabe von Vernetzungsmitteln oder Kettenübertragungs-Reagenzien gesteuert.

Erfindungsgemäße Vernetzungsmittel zur Steuerung des Vernetzungsgrades sind die polyfunktionellen Monomeren (b13) (Vernetzungsmonomere). Beispiele hierfür sind Monomere, die zwei oder mehr zur Copolymerisation befähigte Doppelbindungen enthalten wie Ethylenglykoldiacrylat, Butandioldiacrylat, Hexandioldiacrylat, Ethylenglykoldimethacrylat, Butandioldimethacrylat, Hexandioldimethacrylat, Divinylbenzol, Diallylmaleat, Diallylfumarat, Diallylphthalat, Diallylcyanurat, Tris-allyl-cyanurat, Ester des Tricyclodecenylalkohols wie Tricyclodecenylacrylat, Dihydrodicyclopentadienylacrylat, Diallylphosphat, Allylacrylat, Allylmethacrylat und Dicyclopentadienylacrylat (DCPA).

Bevorzugt werden Ester des Tricyclodecenylalkohols, Divinylbenzol, Allyl(meth)acrylat und/oder Tris-allyl-cyanurat eingesetzt.

Diese sind besonders zur Steuerung des Vernetzungsgrades von Acryl-Polymeren, insbesondere von Acrylnitril-Styrol-Acrylat-Copolymeren (ASA) geeignet.

Erfindungsgemäße Kettenübertragungs-Reagenzien sind z. B. Ethylhexylthioglycolat, n- oder tert-Dodecylmercaptan oder andere Mercaptane, Terpinole und dimeres α-Methylstyrol oder andere, zur Regelung des Molekulargewichts geeigneten Verbindungen. Besonders geeignet sind Ethylhexylthioglycolat, n- oder t-Dodecylmercaptan. Diese sind besonders zur Steuerung des Vernetzungsgrades von Dien-Polymeren, insbesondere von Acrylnitril-Butadien-Styrol-Copolymere (ABS) geeignet.

Die Erfindung betrifft auch ein Verfahren, bei dem zur Bereitstellung des Copolymers (b1') in Abhängigkeit des aus der ersten Polymerisations-Reaktion gemäß Schritt (ii) bestimmten Vernetzungsgrades (V) des Copolymers (b1) dem Reaktions-Gemisch der Polymerisations-Reaktion gemäß Schritt (iii) zusätzlich ein polyfunktionelles, vernetzendes Monomer (b13) als Vernetzungsmittel und/oder ein Kettenübertragungs-Reagenzes (b14) zugegeben wird, oder die Reaktionstemperatur bei der Polymerisations-Reaktion verändert wird, oder eine Kombinationen dieser Maßnahmen erfolgt.

Die Temperaturänderung beträgt dabei vorzugsweise mindestens 10° C, insbesondere mindestens 15° C.

Die Zugabe von Vernetzungsmittel (b13) bzw. Kettenübertragungs-Reagenz (b14) kann allein oder in Kombination miteinander erfolgen. Geeignete Vernetzungsmittel (b13) und Kettenübertragungs-Reagenz (b14) sind die zuvor genannten.

Die Erfindung betriff auch ein Verfahren bei dem im Schritt (iii) dem Reaktionsgemisch ein Kettenübertragungs-Reagenz in einer Konzentration von 0,1 bis 0,6 Gew.-% bezogen auf die gesamte Monomer-Menge des Polymerisationsgemischs zur Herstellung des Copolymers (b1') zugefügt wird.

Im Anschluss an diese zweite Polymerisation gemäß Schritt (iii) wird der Vernetzungsgrad (V) des in Schritt (ii) erhaltenen Copolymers (b1') bestimmt. Dies kann wiederum anhand von Proben des Copolymers (b1'), Proben des dieses Copolymer (b1') enthaltenden Schlagzähmodifikators (b'), oder Proben der daraus hergestellten Polymerzusammensetzung (A') untersucht werden. Bevorzug wird der Vernetzungsgrad anhand des Schlagzähmodifikators (b') oder der Polymerzusammensetzung (A'), insbesondere anhand des Schlagzähmodifikators (b'). Die Messung wird gemäß den zuvor gemachten Ausführungen durchgeführt.

Zeigen die Untersuchungsergebnisse, dass der erhaltenen Vernetzungsgrad (V) nicht dem gewünschten Vernetzungsgrad (V') entspricht, so werden die Schritte (i) bis (iii) beliebig oft wiederholt, bis ein gewünschter Vernetzungsgrad (V') erreicht wird.

### Herstellung der Polymerzusammensetzung (A)

Die Herstellung der hierin gelehrten Polymerzusammensetzung (A) aus den Komponenten (a) und (b) kann nach allen bekannten Methoden erfolgen. Der Polymerzusammensetzung (A) können darüber hinaus gegebenenfalls noch Additive (C) zugegeben werden. Diese werden nachfolgend erläutert. Zur Herstellung der Polymerzusammensetzung ist im Einzelnen das Folgende auszuführen:
Die Schlagzähmodifikatoren (b) mit optimiertem Vernetzungsgrad werden nach dem beschriebenen Verfahren, bevorzugt mittels Emulsionspolymerisation, hergestellt. Der Vernetzungsgrad wird, wie bereits beschrieben, durch geeignete Maßnahmen eingestellt. Dabei ist die Bestimmung des Vernetzungsgrades (V) mittels Messung der transversalen Relaxationszeit T2 in Niederfeld-NMR-Experimenten und die Regulierung des Vernetzungsgrades die Zugabe von Kettenübertragungs-Reagenzien, bevorzugt. Es können stattdessen oder in Kombination auch andere geeignete, dem Fachmann geläufige Maßnahmen ergriffen werden, um den Vernetzungsgrad einzustellen.

Die erhaltene Dispersion der Schlagzähmodifikatoren (b) kann entweder direkt mit den Komponenten (a) und gegebenenfalls (C) vermischt werden, oder sie kann zuvor aufgearbeitet werden.

Die Aufarbeitung der Dispersion der Schlagzähmodifikatoren (b) erfolgt in an sich bekannter Weise. Üblicherweise wird zunächst der Schlagzähmodifikator (b) aus der Dispersion ausgefällt, beispielsweise durch Zugabe von fällend wirkenden Salzlösungen (wie Calciumchlorid, Magnesiumsulfat, Alaun) oder Säuren (wie Essigsäure, Salzsäure oder Schwefelsäure) oder auch durch Einfrieren (Gefrierkoagulation). Die wässrige Phase kann in üblicher Weise, etwa durch Sieben, Filtrieren, Dekantieren oder Zentrifugieren, abgetrennt werden. Man erhält durch diese vorherige Abtrennung des Dispersionswassers wasserfeuchte Schlagzähmodifikatoren (b) mit einem Restwassergehalt von bis zu 60 Gew.-%, bezogen auf (b), wobei das Restwasser z. B. sowohl am Schlagzähmodifikator (b) äußerlich anhaften als auch darin eingeschlossen sein kann.

Der Schlagzähmodifikator (b) kann danach erforderlichenfalls in bekannter Weise weiter getrocknet werden, z. B. durch Warmluft oder mittels eines Stromtrockners. Ebenso ist es möglich, die Dispersion durch Sprühtrocknung aufzuarbeiten. Die Schlagzähmodifikatoren (b) werden mit dem Styrol-Copolymer (a) und, sofern enthalten, den weiteren Additiven (C), in einer Mischvorrichtung vermischt, wobei eine im Wesentlichen schmelzflüssige Polymerzusammensetzung entsteht.

"Im Wesentlichen schmelzflüssig" bedeutet, dass das Polymerzusammensetzung neben dem überwiegenden, schmelzflüssigen (erweichten) Anteil noch einen gewissen Anteil fester Bestandteile enthalten kann, beispielsweise ungeschmolzene Füll- und Verstärkungsstoffe wie Glasfasern, Metallflocken, oder auch ungeschmolzene Pigmente, Farbstoffe etc.. "Schmelzflüssig" bedeutet, dass das Polymerzusammensetzung zumindest zähflüssig ist, sie also zumindest in dem Maß erweicht ist, dass sie plastische Eigenschaften hat.

Als Mischvorrichtungen werden solche verwendet, die dem Fachmann bekannt sind. Man kann die Komponenten (a) und (b), und - sofern enthalten - (C) beispielsweise durch gemeinsames Extrudieren, Kneten oder Verwalzen vermischen, wobei die vorgenannten Komponenten notwendigenfalls zuvor aus der bei der Polymerisation erhaltenen Lösung oder aus der wässrigen Dispersion isoliert worden sind.

Im Falle des Einmischens einer oder mehrerer Komponenten in Form einer wässrigen Dispersion bzw. einer wässrigen oder nichtwässrigen Lösung, wird das Wasser bzw. das Lösungsmittel über eine Entgasungseinheit aus der Mischvorrichtung, bevorzugt einem Extruder, entfernt.

Als Mischvorrichtungen für die Durchführung des Verfahrens sind beispielsweise diskontinuierlich arbeitende, beheizte Innenkneter mit oder ohne Stempel, kontinuierlich arbeitende Kneter wie z. B. kontinuierliche Innenkneter, Schneckenkneter mit axial oszillierenden Schnecken, Banbury-Kneter, weiterhin Extruder sowie Walzenstühle, Mischwalzwerke mit beheizten Walzen und Kalander, zu nennen.

Bevorzugt wird als Mischvorrichtung ein Extruder verwendet. Für die Schmelzextrusion sind beispielsweise Ein- oder Zweiwellenextruder besonders geeignet. Ein Zweiwellenextruder ist bevorzugt.

In manchen Fällen bewirkt die beim Vermischen durch die Mischvorrichtung eingebrachte mechanische Energie bereits ein Schmelzen der Mischung, so dass die Mischvorrichtung nicht beheizt werden muss. Ansonsten wird die Mischvorrichtung in der Regel beheizt. Die Temperatur richtet sich nach den chemischen und physikalischen Eigenschaften der Komponenten (a) und (b), und - sofern enthalten - (C), und ist so zu wählen, dass eine im Wesentlichen schmelzflüssige Polymerzusammensetzung entsteht. Andererseits soll die Temperatur nicht unnötig hoch sein, um eine thermische Schädigung der Polymerzusammensetzung zu vermeiden. Die eingebrachte mechanische Energie kann jedoch auch so hoch sein, dass die Mischvorrichtung sogar gekühlt werden muss. Üblicherweise betreibt man die Mischvorrichtung bei 160 bis 400, bevorzugt 180 bis 300°C.

In einer bevorzugten Ausführungsform erfolgt das Vermischen des Schlagzähmodifikators (b) mit dem Styrol-Copolymer (a) und, sofern enthalten, der weiteren Komponente (C), in einem Extruder, wobei die Dispersion des Schlagzähmodifikators (b) ohne vorherige Abtrennung des Dispersionswassers direkt in den Extruder eindosiert wird. Das Wasser wird üblicherweise entlang des Extruders über geeignete Entgasungsvorrichtungen entfernt. Als Entgasungsvorrichtungen können beispielsweise Entgasungsöffnungen, die mit Rückhalteschnecken versehen sind (welche das Austreten der Polymerzusammensetzung verhindern), eingesetzt werden.

In einer anderen, ebenfalls bevorzugten Ausführungsform erfolgt das Vermischen der vorgenannten Komponenten, in einem Extruder, wobei der Schlagzähmodifikator (b) zuvor vom Dispersionswasser abgetrennt wird. Man erhält durch diese vorherige Abtrennung des Dispersionswassers wasserfeuchte Schlagzähmodifikatoren (b) mit einem Restwassergehalt von bis zu 60 Gew.-%, bezogen auf (b). Das vorhandene Restwasser kann dann, wie zuvor beschrieben, über Entgasungseinrichtungen des Extruders als Dampf entfernt werden.

Besonders bevorzugt wird jedoch das Restwasser im Extruder nicht allein als Dampf entfernt, sondern es wird ein Teil des Restwassers mechanisch im Extruder entfernt und verlässt den Extruder in flüssiger Phase. Bei diesem sogenannten Abquetschverfahren (EP 0 993 476 B1, S. 13-16) werden dem gleichen Extruder die Polymerzusammensetzung (A) und - sofern vorhanden - die Komponente (C) zugeführt, so dass als Produkt des Verfahrens die fertige Polymerzusammensetzung (A) extrudiert wird.

Die hierin gelehrte Polymerzusammensetzung (A) zeichnet sich dadurch aus, dass deren Restmonomergehalt nicht mehr als 2000 ppm, vorzugsweise nicht mehr als 1000 ppm, besonders bevorzugt nicht mehr als 500 ppm beträgt. Unter Restmonomergehalt ist der Anteil an nicht umgesetztem (nicht einpolymerisierten) Monomer in der Polymerzusammensetzung zu verstehen.

Ferner zeichnet sich die hierin gelehrte Polymerzusammensetzung (A) dadurch aus, dass deren Lösungsmittelgehalt wie z.B. von Ethylbenzol, Toluol usw. nicht mehr als 1000 ppm, vorzugsweise nicht mehr als 500 ppm, besonders bevorzugt nicht mehr als 200 ppm beträgt.

Der geringe Restmonomer- und Lösungsmittelgehalt kann dadurch erzielt werden, dass übliche Verfahren zur Reduzierung von Restmonomeren und Lösungsmitteln aus Polymerschmelzen, wie z.B. im Kunststoffhandbuch, Hrg. R. Vieweg und G. Daumiller, Bd. 4 "Polystyrol", Carl-Hanser-Verlag München (1996), S. 121 bis 139 beschrieben, angewandt werden. In diesen Verfahren werden typische Entgasungsapparate wie beispielsweise Teilverdampfer, Flachverdampfer, Strang-Entgaser, Dünnschichtverdampfer, Entgasungsextruder etc. eingesetzt.

Darüber hinaus enthält die Polymerzusammensetzung (A) nicht mehr als 500 ppm, bevorzugt nicht mehr als 400 ppm, besonders bevorzugt nicht mehr als 300 ppm von Übergangsmetallen wie beispielsweise Fe, Mn und Zn.

Polymerzusammensetzungen (A) mit einem solchen niedrigen Gehalt an Übergangsmetallen lassen sich beispielsweise dadurch erhalten, dass, falls zum Starten der Polymerisation der in der Polymerzusammensetzung enthaltenen Polymere RedoxInitiatoren eingesetzt werden, diese Redoxinitiatoren nur in geringen Mengen in Kombination mit Peroxiden verwendet werden. Weiterhin sollten deshalb in der Polymerzusammensetzung (A) nur geringe Mengen an übergangsmetallhaltigen Mineralien (z.B. Pigmente) enthalten sein.

Die Viskosität der gesamten Polymerzusammensetzung (A) ist bei Scherraten von 1 bis 10 s⁻¹ und bei Temperaturen von 250 °C nicht höher als 1x10⁵ Pa*s, vorzugsweise nicht höher als 1x10⁴ Pa*s, besonders bevorzugt nicht höher als 1x10³ Pa*s.

Die Melt Volume Rate (MVR, gemessen nach ISO 1133 bei 220°C und 10 kg Last) beträgt im Allgemeinen mehr als 6 ml/10 min, bevorzugt mehr als 8 ml/10 min, besonders bevorzugt mehr als 12 ml/10 min.

Die Polymerzusammensetzung (A) kann insbesondere zur Herstellung thermoplastischer Formmassen verwendet werden, welche zu Formteilen, Folien oder Beschichtungen weiter verarbeitet werden können. Dazu wird eine Polymerzusammensetzung (A) verwendet, welcher gegebenenfalls ferner ein oder mehrere weitere Polymer(e) (B) und gegebenenfalls Additive (C) zugefügt werden.

In der Formmasse beträgt der Anteil der Polymerzusammensetzung (A) im Allgemeinen 40 bis 100 Gew.-%, bevorzugt 70 bis 100 Gew.-%, ganz besonders bevorzugt 80 bis 100 Gew.-%, bezogen auf die gesamte Formmasse.

Die Formmasse kann gegebenenfalls zusätzlich mindestens ein weiteres Polymer (B) enthalten (das sich von (A) unterscheidet), ausgewählt aus der Gruppe: Polycarbonate, Polyamide, Poly(meth)acrylate, Polyester und Vinylaromat-Dien-Copolymeren (SBC). Bevorzugt als Polymer (B) sind Polycarbonate, Polyamide und/oder Poly(meth)acrylate. Der Anteil des Polymers (B) beträgt im Allgemeinen 0 bis 60 Gew.-%, bevorzugt 0 bis 30 Gew.-%, besonders bevorzugt 0 bis 20 Gew.-%, bezogen auf die gesamte Formmasse. Falls Polymer (B) in der Formmasse vorhanden ist, beträgt dessen Mindestanteil üblicherweise 0,1 Gew.-%.

Ferner kann die Formmasse gegebenenfalls übliche Additive (C) enthalten, wie Stabilisatoren, Oxidationsverzögerer, Mittel gegen Wärmezersetzung und Zersetzung durch ultraviolettes Licht, Gleit- und Entformungsmittel, Färbemittel wie Farbstoffe und Pigmente, faser- und pulverförmige Füll- und Verstärkungsmittel, Keimbildungsmittel, Weichmacher usw. enthalten. Der Anteil der Additive (C) beträgt im Allgemeinen 0 bis 50 Gew.-%, bevorzugt 0 bis 30, oftmals 0,1 bis 30, besonders bevorzugt 0,2 bis 10 Gew.-%, bezogen auf die gesamte Formmasse.

Falls Additive (C) in der Formmasse vorhanden sind, beträgt deren Mindestanteil üblicherweise 0,1 Gew.-%. Die Summe der in der gesamten Formmasse enthaltenen Komponenten (A) und gegebenenfalls (B) und/oder (C) ergibt 100 Gew.-%. Bevorzugt enthält eine hierin gelehrte Formmasse die Komponenten (A), (B) und (C) oder besteht aus diesen.

Falls die Formmasse als Additiv (C) keine oder nur geringe Mengen (0 bis 5 Gew.-%, bezogen auf die gesamte Formmasse) Mineralien wie faser- und pulverförmige Füll- und Verstärkungsmittel und/oder Pigmente enthält, beträgt in der Polymerzusammensetzung (A) vorzugsweise der Anteil des Polymers (a) 70 bis 95 Gew.-% und der Anteil des Schlagzähmodifikators (b) 5 bis 30 Gew.-%.

Weiterhin bevorzugt enthält die eingesetzte Formmasse im Wesentlichen amorphe Polymere, d.h. mindestens die Hälfte der in der Formmasse enthaltenen Polymere sind amorphe Polymere.

Die Erfindung wird durch die nachfolgenden Beispiele und Ansprüche näher erläutert:

### Beispiele

Zunächst werden die zur Charakterisierung der Polymere eingesetzten Untersuchungsmethoden kurz zusammengefasst:

### a) Kautschukgehalt

Der Kautschukgehalt der erhaltenen Copolymere wurde mittels IR-Spektroskopie ermittelt. Dazu wird aus dem gemessenen Verhältnis von Butadien zu Styrol zu Acrylnitril (jeweils in polymerer Form) der finale Kautschukgehalt berechnet. Dazu wird ein Film mit einer Schichtstärke von ungefähr 20 µm in einer Presse bei 180°C hergestellt und in Transmission IR-spektroskopisch vermessen. Die Absorptionen der Banden bei 910 cm⁻¹ und 965 cm⁻¹ für die 1,2-Vinyl- und 1,4-trans-Polybutadieneinheiten, die Absorption der Bande bei 2238 cm⁻¹ für die Nitrilgruppe des polymerisierten Acrylnitrils und die Absorption der Bande bei 1495 cm⁻¹ für die Phenylgruppe des polymerisierten Styrols werden zur Berechnung des Verhältnisses unter Verwendung einer Kalibration mit Proben von bekannter Zusammensetzung herangezogen.

### b) Charpy-Kerbschlagzähigkeit [kJ/m²]:

Die Kerbschlagzähigkeit wird ermittelt an Probekörpern (80 x 10 x 4 mm, hergestellt durch Spritzguss bei einer Massetemperatur von 240°C und einer Werkzeugtemperatur von 70°C), bei 23°C nach ISO 179-1A

### c) Fließfähigkeit (MVR [ml/10 min]):

Die Fließfähigkeit wird ermittelt an einer Polymerschmelze bei 220°C und 10 kg Belastung nach ISO 1133.

### d) Oberflächenglanz

Zur Bestimmung des Oberflächenglanzes werden mittels einer Spritzgussmaschine bei einer Massetemperatur von 240°C und einer Werkzeugtemperatur von 70°C rechteckige Plättchen mit den Abmessungen 60 mm x 40 mm x 2 mm aus der Polymerschmelze hergestellt. Der Oberflächenglanz wird durch Reflektionsmessung nach DIN 67530 bei einem Winkel von 20° gemessen.

### e) Yellowness Index YI

Die Bestimmung des YI-Wertes erfolgte an Plättchen mit den Abmessungen 60 x 40 x 2 mm, hergestellt durch Spritzguss bei einer Massetemperatur von 240°C und einer Werkzeugtemperatur von 70°C nach ASTM-Methode E313-96 (Lichtart / Beobachter-Kombination (C) / 2 °).

### Beispiel 1

### Erfindungsgemäße Herstellung des Co-Polymers (b1)

Die Herstellung des Co-Polymers (b1) erfolgt durch Emulsionspolymerisation nach dem Zulaufverfahren. Als Monomer wird Butadien eingesetzt, als Co-Monomer werden 7 Gew.-% Styrol verwendet. Die Emulsionspolymerisation wird in einem 150 L- Reaktor bei einer Temperatur von 67 °C durchgeführt. 43120 g der Monomermischung (Butadien und Styrol) werden bei 67 °C in Anwesenheit von 229,8 g (0,533 Teile bezogen auf die gesamte Monomer-Menge) tert.-Dodecylmercaptan (TDM), 320,8 g Kaliumstearat, 106,1 g Kaliumpersulfat, 151,4 g Natriumhydrogencarbonat und 58400 g Wasser polymerisiert, wobei ein Latex der Pfropfgrundlage mit einem Feststoffgehalt von 42,1 Gew.-% erhalten wird.

Die Monomere werden in der im Folgenden aufgeführten Reihenfolge in den Reaktor gegeben:
Zunächst erfolgt die Zugabe von Styrol in einer Menge von 7 Gew.-%, bezogen auf die gesamte Monomermenge, innerhalb von 20 Minuten. Im Anschluss an die Styrol-Zugabe erfolgt die Zugabe von 0,527 Gew.-% Styrol und 6,473 Gew.-% Butadien, bezogen auf die gesamte Monomermenge, innerhalb von 25 Minuten.

Der restliche Teil der Monomere, der 86 Gew.-%, bezogen auf die gesamte Monomermenge, entspricht und aus 6,473 Gew.-% Styrol und 79,527 Gew.-% Butadien besteht, wird anschließend innerhalb von 8,5 Stunden zugegeben. TDM wird als Spritze bei 71 Minuten (41,7% der Gesamtmenge TDM), bei 260 Minuten (41,7% der Gesamtmenge) und bei 500 Minuten (16,6% der Gesamtmenge TDM) zugegeben. Am Ende der Polymerisationszeit beträgt der Umsatz ≥ 95 %.

### Bestimmung des Vernetzungsgrades

Den erfindungsgemäß hergestellten Co-Polymer-Latices werden in verschiedenen Versuchsreihen Proben entnommen. Die Proben werden über Nacht abgelüftet und bei 80°C im Vakuum 3 Stunden nachgetrocknet, um verfilmte Proben zu erhalten. Diese werden bei 30°C und 140°C nach einer Standard-Methode mittels Festkörper-Echo und Hahn-Echo untersucht. Es werden Relaxationszeiten T2 (30°C) von 1,28 ms bis 1,72 ms sowie T2 (140°C) von 3,96 ms bis 5,00 ms gemessen. Der Vernetzungsgrad wird anhand der ermittelten Relaxationszeiten T2 bestimmt.

### Herstellung des Schlagzähmodifikators (b)

### Allgemeine Vorgehensweise:

Zuerst werden 59 Gew.-Teile des Latex der Pfropfgrundlage (b1), bezogen auf den Feststoffgehalt des Latex, bei einer Temperatur von 68°C vorgelegt und gerührt. 1,357 Gew.-Teile eines Latex (bezogen auf Feststoffe des Latex) eines agglomerierend wirkenden Copolymers aus 96 Gew.-% Ethylacrylat und 4 Gew.-% Methacrylsäureamid, werden mit entmineralisiertem Wasser auf 10 Gew.-% eingestellt.

Dieser verdünnte Latex wird zur Agglomeration der Pfropfgrundlage (b1) innerhalb von 25 Minuten unter Rühren zugegeben. Nach 5 Minuten werden 0,56 Gew.-Teile Kaliumstearat, gelöst in 40,98 Gew.-Teilen entmineralisiertem Wasser von 68°C, dem Latex der Pfropfgrundlage (b1) unter fortgesetztem Rühren zugesetzt.

Nach Beendigung des Agglomerationsschrittes werden 0,074 Gew.-Teile Kaliumpersulfat, gelöst in 3,13 Gew.-Teilen entmineralisiertem Wasser, dem agglomerierten Latex der Pfropfgrundlage (b1) bei 68°C unter fortgesetztem Rühren zugesetzt. Ein Monomergemisch von 32,8 Gew.-Teilen Styrol und 8,2 Gew.-Teilen Acrylnitril wird innerhalb von 2 Stunden und 44 Minuten zugegeben, während das Rühren fortgesetzt wird. Innerhalb dieses Zeitraums der Zuführung des Styrol/Acrylnitril-Gemisches wird die Temperatur auf 80°C erhöht. Nach Beendigung der Zuführung des Styrol/Acrylnitril-Gemisches werden 0,074 Gew.-Teile Kaliumpersulfat, gelöst in 3,13 Gew.-Teilen entmineralisiertem Wasser, unter fortgesetztem Rühren zugesetzt. Die Polymerisation wird 80 Minuten bei 80°C fortgesetzt und der erhaltene Latex des Pfropfcopolymers (b) wird auf Umgebungstemperatur abgekühlt.

Zu dem erhaltenen Pfropflatex werden 0,37 Gew.-Teile einer Dispersion eines Stabilisators (bezogen auf Feststoffe der Dispersion mit einem Feststoffgehalt von 60 Gew.-%) zugegeben. Im Anschluss daran wird die Dispersion des Pfropfcopolymers mit Hilfe einer wässrigen Lösung eines Fällungsmittels in einem dampfbeheizten Fäll-Kessel mit Rührer bei 4 bar und bei einer Temperatur von 88°C ausgefällt. Zur Fällung wird die wässrige Lösung des Fällungsmittels in dem dampfbeheizten Fäll-Kessel vorgelegt, und nach Erreichen einer Temperatur von 88°C wird die Dispersion des Pfropfcopolymers langsam unter Rühren zudosiert.

Danach wird die Fäll-Suspension in einen dampfbeheizten Sinterkessel mit Rührer überführt. Das Sintern erfolgt bei 4 bar und 116°C für 60 Minuten. Anschließend wird das gesinterte Propfcopolymer in einer Zentrifuge geschleudert, zweimal mit 550 Gew.-Teilen entmineralisiertem Wasser gewaschen. Das so aufgearbeitete Polymer wird mit einer Restfeuchte von 15 bis 30 % mittels Extrusion weiterverarbeitet.

### Vergleichsbeispiel 1

### Herstellung des Vergleich-Co-Polymers (V-b1) nach herkömmlichem Verfahren

Die Herstellung des Vergleichs-Co-Polymer (V-b1) erfolgt durch Emulsionspolymerisation nach dem Zulaufverfahren wie dies im Beispiel 1 beschrieben ist. Der Unterschied besteht darin, dass 345,4 g (0,801 Teile bezogen auf die gesamte Monomer-Menge) tert-Dodecylmercaptan (TDM) verwendet werden.

### Herstellung des Vergleichs-Schlagzähmodifikators (V-b)

Der Vergleichsschlagzähmodifikator (V-b) wurde entsprechend der Vorschrift für die Herstellung des erfindungsgemäßen Schlagzähmodifikators (b) hergestellt, mit dem Unterschied dass als Pfropfgrundlage der Vergleichs-Schlagzähmodifikator (V-b1) verwendet wurde.

### Beispiel 2

### Herstellung von Polymerzusammensetzung (A) aus SAN-Copolymer (a) und Schlagzähmodifikator (b)

Aus dem Schlagzähmodifikator (b) werden die Polymerzusammensetzungen (A1) bis (A5) hergestellt. Dazu wird der Schlagzähmodifikator (b) mit dem Styrol-Copolymer (a) in den in Tabelle 1 angegebenen Anteilen (bezogen auf die gesamte Polymerzusammensetzung) unter Zusatz von 1 Gew.-% des unten beschriebenen Stabilisator-Masterbatches in einem Doppelschneckenextruder mit einem Wellendurchmesser von 25 mm gemischt. In der Extrusionszone wird die Temperatur auf 200 bis 250°C eingestellt und die Verarbeitung erfolgte bei 700 UpM des Doppelschneckenextruders. Die Batch-Größe für alle Beispiele ist 4 kg.

Als Styrol-Copolymer (a) wird eine statistisches Copolymer aus Styrol und Acrylnitril (SAN-Copolymer) mit einem Acrylnitril-Gehalt von 24 Gew.-% mit einem Mw von 120000 g/mol, einer Viskositätszahl von 64 ml/g (Konzentration 5 g/l in Dimethylformamid bei 20°C gemessen) und einer Schmelzflussrate MVR von 64 ml/10 min, gemessen bei 220°C und 10 kg Belastung nach ISO 1133 gewählt.

Das Stabilisatormasterbatch ist ein Masterbatch mit thermischen und LichtStabilisatoren wie z.B. Tinuvin 770, Cyasorb 3853, Chimasorb 944 in SAN-Polymer (Luran VLN).

**Tabelle 1**

| Polymerzusammensetzung (A) | Eingesetzte Menge an Schlagzähmodifikator (b) in Gew.-% | Eingesetzte Menge an SAN-Polymer (a) in Gew-% | Eingesetzte Menge an StabilisatorMasterbatch in Gew.-% |
|---|---|---|---|
| A1 | 29 | 80 | 1 |
| A2 | 31 | 78 | 1 |
| A3 | 33 | 76 | 1 |
| A4 | 35 | 74 | 1 |
| A5 | 37 | 72 | 1 |

Mit den erhaltenen ABS-Zusammensetzungen wurden Tests zur Bestimmung der Charpy-Kerbschlagzähigkeit, Fließfähigkeit (MVR), des Yellowness Index (YI), und des Oberflächenglanzes durchgeführt. Dabei wurden die oben aufgeführten Testmethoden angewandt.

Der in den Proben vorliegende Kautschukgehalt wurde durch die eingangs beschriebenen IR-Messungen an den hergestellten Granulaten bestimmt.

In Tabelle 2 sind die Testergebnisse der untersuchten ABS-Zusammensetzungen zusammengefasst.

### Vergleichsbeispiel 2

Zum Vergleich werden die Vergleichspolymerzusammensetzungen V-A1 bis V-A5 hergestellt, welche sich nur darin von den Polymerzusammensetzungen A1 bis A5 unterscheiden, dass zur Herstellung der Vergleichsformmassen der Vergleichsschlagzähmodifikator (V-b) verwendet wird.

Mit den erhaltenen ABS-Zusammensetzungen werden Tests zur Bestimmung der Charpy-Kerbschlagzähigkeit, Fließfähigkeit (MVR), des Yellowness Index (YI), und des Oberflächenglanzes durchgeführt. Dabei wurden die oben aufgeführten Testmethoden angewandt.

Der in den Proben vorliegende Kautschukgehalt wurde durch die eingangs beschriebenen IR-Messungen an den hergestellten Granulaten bestimmt.

In den Tabelle 2 sind die Testergebnisse der untersuchten ABS-Zusammensetzungen zusammengefasst.

**Tabelle 2**

| | Kautschukgehalt [%] | Charpy ak [kJ/m²] | MVR [ml/10min] | Yellowness Index | Oberflächenglanz bei 20° |
|---|---|---|---|---|---|
| V-A1 | 30,0 | 11 | 16,5 | 34,58 | 97,3 |
| V-A2 | 31,4 | 12,8 | 15,3 | 34,74 | 94,1 |
| V-A3 | 33,0 | 15,4 | 13,1 | 35,82 | 92 |
| V-A4 | 35,6 | 18,3 | 11,2 | 34,89 | 92,8 |
| V-A5 | 36,2 | 20,7 | 9,2 | 36,7 | 92,1 |
| A1 | 27,4 | 11,6 | 21 | 34,2 | 95,8 |
| A2 | 29,2 | 14 | 17,6 | 35,8 | 94,4 |
| A3 | 32,2 | 16,5 | 16,5 | 36,7 | 94,8 |
| A4 | 32,8 | 17,6 | 14 | 37,1 | 95,1 |
| A5 | 33,8 | 21 | 11,6 | 36,5 | 94,1 |

Die Ergebnisse zeigen, dass die Polymerzusammensetzungen, welche nach dem erfindungsgemäßen Verfahren hergestellt wurden, deutlich bessere mechanische Eigenschaften aufweisen. Dies kann mit der verbesserten Vernetzung der Kautschuk-Komponente erklärt werden, die durch das vorliegende Verfahren erreicht wurde, welches eine Verringerung des eingesetzten Kettenübertragungs-Reagenz ermöglicht. Auf die übrigen der genannten Eigenschaften der Polymere hat das erfindungsgemäße Verfahren keine merkbar negativen Einflüsse.

Das erfindungsgemäße Verfahren ermöglicht es, die Eigenschaften von schlagzähmodifizierten Polymerzusammensetzungen zu verbessern und gleichzeitig den Einsatz von kostenintensiven und potentiell gesundheits- und/oder umweltschädlichen Zusatzstoffen in der Polymerzusammensetzung zu reduzieren.

### Beispiel 3

80% der Polymerzusammensetzung A1 werden mit 20% Polycarbonat (auf Bisphenol-A-Basis) in einem Doppelschneckenextruder mit einem Wellendurchmesser von 25 mm gemischt. In der Extrusionszone wurde die Temperatur auf 200 bis 250°C eingestellt und die Verarbeitung erfolgte bei 700 UpM des Doppelschneckenextruders. Aus dem Polymer-Blend wird ein Formkörper hergestellt.

## Patentansprüche

1. Verfahren zur Optimierung des Vernetzungsgrades (V) eines vernetzten Copolymers (b1) als Pfropfgrundlage für einen polymeren Schlagzähmodifikator (b), hergestellt aus einem Monomeren-Gemisch, umfassend:
(b11): 70 bis 99,99 Gew.-% mindestens eines konjugierten Diens und/oder mindestens eines Acrylats,
(b12): 0 bis 29 Gew.-% mindestens eines weiteren Comonomers ausgewählt aus: Styrol, α-Methylstyrol, Acrylnitril, Methacrylnitril und Methylmethacrylat,
(b13): 0 bis 10 Gew.-% eines oder mehrerer polyfunktioneller, vernetzender Monomere, und
(b14): 0,01 bis 0,7 Gew.-% eines Kettenübertragungs-Reagenzes,
bezogen auf die gesamte Monomer-Menge des Polymerisationsgemischs zur Herstellung des Copolymers (b1);
wobei das Verfahren die folgenden Schritte umfasst:
(i) Polymerisieren des Monomeren-Gemisches zur Herstellung des Copolymers (b1);
(ii) Bestimmen des Vernetzungsgrades (V) des in Schritt (i) erhaltenen Copolymers (b1) mittels NMR-Relaxationsmessungen;
(iii) Polymerisieren eines modifizierten Monomeren-Gemisches zur Herstellung eines modifizierten Copolymers (b1'), wobei die Parameter der Polymerisations-Reaktion in Abhängigkeit des gemäß Schritt (ii) ermittelten Vernetzungsgrads (V) des Copolymers (b1) und des gewünschten Vernetzungsgrads (V') des Copolymers (b1') als Pfropfgrundlage angepasst werden; und
(iv) gegebenenfalls Wiederholen der Schritte (i) bis (iii), bis ein gewünschter Vernetzungsgrad (V') erreicht wird, und wobei
zur Bestimmung des Vernetzungsgrades (V) des Copolymers (b1) die transversale Relaxationszeit T2 gemessen an flüssigen Polymerdispersionen bei 20°C bis 50°C verwendet wird, und
die Bestimmung des Vernetzungsgrades (V) des Copolymers (b1) unter Verwendung eines Niedrigfeld-NMR-Spektrometers bei einer Feldstärke im Bereich von 0,001 bis 1,5 Tesla, vorzugsweise 0,1 bis 0,6 Tesla erfolgt.

2. Verfahren nach Anspruch 1, **dadurch gekennzeichnet, dass** die Relaxationszeit T2 gemessen an flüssigen Polymerdispersionen mittels einer Solid-Echo-Carr-Purcell-Meiboom-Gill-Sequenz-Methode (SE-CPMG) bestimmt wird.

3. Verfahren nach Anspruch 1 oder 2, **dadurch gekennzeichnet, dass** zur Bereitstellung des Copolymers (b1') in Abhängigkeit des aus der ersten Polymerisations-Reaktion gemäß Schritt (ii) bestimmten Vernetzungsgrades (V) des Copolymers (b1) dem Reaktions-Gemisch der Polymerisations-Reaktion gemäß Schritt (iii) zusätzlich ein polyfunktionelles, vernetzendes Monomer (b13) als Vernetzungsmittel und/oder ein Kettenübertragungs-Reagenz (b14) zugegeben wird, oder die Reaktionstemperatur bei der Polymerisations-Reaktion verändert wird, oder eine Kombinationen dieser Maßnahmen erfolgt.

4. Verfahren zur Optimierung des Vernetzungsgrades (V) eines vernetzten Copolymers (b1) als Pfropfgrundlage für einen polymeren Schlagzähmodifikator (b), hergestellt aus einem Monomeren-Gemisch, umfassend:
(b11): 70 bis 99,99 Gew.-% mindestens eines konjugierten Diens und/oder mindestens eines Acrylats,
(b12): 0 bis 29 Gew.-% mindestens eines weiteren Comonomers ausgewählt aus: Styrol, α-Methylstyrol, Acrylnitril, Methacrylnitril und Methylmethacrylat,
(b13): 0 bis 10 Gew.-% eines oder mehrerer polyfunktioneller, vernetzender Monomere, und
(b14): 0,01 bis 0,7 Gew.-% eines Kettenübertragungs-Reagenzes,
bezogen auf die gesamte Monomer-Menge des Polymerisationsgemischs zur Herstellung des Copolymers (b1);
wobei das Verfahren die folgenden Schritte umfasst:
(i) Polymerisieren des Monomeren-Gemisches zur Herstellung des Copolymers (b1);
(ii) Bestimmen des Vernetzungsgrades (V) des in Schritt (i) erhaltenen Copolymers (b1) mittels NMR-Relaxationsmessungen;
(iii) Polymerisieren eines modifizierten Monomeren-Gemisches zur Herstellung eines modifizierten Copolymers (b1'), wobei die Parameter der Polymerisations-Reaktion in Abhängigkeit des gemäß Schritt (ii) ermittelten Vernetzungsgrads (V) des Copolymers (b1) und des gewünschten Vernetzungsgrads (V') des Copolymers (b1') als Pfropfgrundlage angepasst werden; und
(iv) gegebenenfalls Wiederholen der Schritte (i) bis (iii), bis ein gewünschter Vernetzungsgrad (V') erreicht wird, und wobei
zur Bestimmung des Vernetzungsgrades (V) des Copolymers (b1) die transversale Relaxationszeit T2 verwendet wird,
die Bestimmung des Vernetzungsgrades (V) des Copolymers (b1) unter Verwendung eines Niedrigfeld-NMR-Spektrometers bei einer Feldstärke im Bereich von 0,001 bis 1,5 Tesla, vorzugsweise 0,1 bis 0,6 Tesla erfolgt, und
die T2-Zeiten für die Pfropfgrundlagen (b1) im Bereich 2,0 bis 7 ms, gemessen an verfilmten Proben bei 140°C, liegen,
**dadurch gekennzeichnet, dass** zur Bereitstellung des Copolymers (b1') in Abhängigkeit des aus der ersten Polymerisations-Reaktion gemäß Schritt (ii) bestimmten Vernetzungsgrades (V) des Copolymers (b1) dem Reaktions-Gemisch der Polymerisations-Reaktion gemäß Schritt (iii) zusätzlich ein polyfunktionelles, vernetzendes Monomer (b13) als Vernetzungsmittel und/oder ein Kettenübertragungs-Reagenz (b14) zugegeben wird, oder die Reaktionstemperatur bei der Polymerisations-Reaktion verändert wird, oder eine Kombinationen dieser Maßnahmen erfolgt.

5. Verfahren nach einem der Ansprüche 1, 2 und 3 oder nach Anspruch 4, **dadurch gekennzeichnet, dass** zur Bereitstellung des Copolymers (b1') das Reaktions-Gemisch der Polymerisations-Reaktion einer Temperatur-Änderung um mindestens 10°C unterzogen wird.

6. Verfahren nach einem der Ansprüche 1, 2, 3 und 5 oder nach einem der Ansprüche 4 und 5, **dadurch gekennzeichnet, dass** dem Reaktionsgemisch ein Kettenübertragungs-Reagenz in einer Menge von 0,1 bis 0,6 Gew.-%, bezogen auf die gesamte Monomer-Menge des Polymerisationsgemischs zur Herstellung des Copolymers (b1'), zugefügt wird.

## Claims

1. Process for optimizing the degree of crosslinking (V) of a crosslinked copolymer (b1) as graft substrate for a polymeric impact modifier (b) produced from a monomer mixture comprising:
(b11): 70 to 99.99 wt% of at least one conjugated diene and/or of at least one acrylate,
(b12): 0 to 29 wt% of at least one further comonomer selected from: styrene, α-methylstyrene, acrylonitrile, methacrylonitrile, and methyl methacrylate,
(b13): 0 to 10 wt% of one or more polyfunctional crosslinking monomers, and
(b14): 0.01 to 0.7 wt% of a chain transfer agent,
based on the entire monomer quantity of the polymerization mixture for producing said copolymer (b1);
wherein the process comprises the steps of:
(i) polymerizing the monomer mixture for producing said copolymer (b1);
(ii) determining via NMR relaxation measurements the degree of crosslinking (V) of said copolymer (b1) obtained in step (i);
(iii) polymerizing a modified monomer mixture to produce a modified copolymer (b1'), wherein the parameters of the polymerization reaction are adapted according to said crosslinking (V) determined as per step (ii) for said copolymer (b1) and according to the desired crosslinking (V') of said copolymer (b1') as graft substrate; and
(iv) repeating said steps (i) to (iii) as often as necessary until a desired degree of crosslinking (V') is obtained, and wherein
the transversal relaxation time T2 measured on liquid polymer dispersions at 20°C to 50°C is used to determine said degree of crosslinking (V) of said copolymer (b1), and
said degree of crosslinking (V) of said copolymer (b1) is determined by using a low-field NMR spectrometer at a field strength ranging from 0.001 to 1.5 teslas, preferably from 0.1 to 0.6 tesla.

2. Process according to Claim 1, **characterized in that** the relaxation time T2 measured on liquid polymer dispersions is determined by means of a Solid Echo Carr/Purcell/Meiboom/Gill sequence method (SE-CPMG).

3. Process according to Claim 1 or 2, **characterized in that** the step of providing said copolymer (b1') according to said degree of crosslinking (V) determined in step (ii) for said copolymer (b1) resulting from the first polymerization reaction is carried out by admixing the reaction mixture of the polymerization reaction as per step (iii) additionally with a polyfunctional crosslinking monomer (b13) as crosslinking agent and/or a chain transfer agent (b14), or changing the reaction temperature in the polymerization reaction, or a combination thereof.

4. Process for optimizing the degree of crosslinking (V) of a crosslinked copolymer (b1) as graft substrate for a polymeric impact modifier (b) produced from a monomer mixture comprising:
(b11): 70 to 99.99 wt% of at least one conjugated diene and/or of at least one acrylate,
(b12): 0 to 29 wt% of at least one further comonomer selected from: styrene, α-methylstyrene, acrylonitrile, methacrylonitrile, and methyl methacrylate,
(b13): 0 to 10 wt% of one or more polyfunctional crosslinking monomers, and
(b14): 0.01 to 0.7 wt% of a chain transfer agent,
based on the entire monomer quantity of the polymerization mixture for producing said copolymer (b1);
wherein the process comprises the steps of:
(i) polymerizing the monomer mixture for producing said copolymer (b1);
(ii) determining via NMR relaxation measurements the degree of crosslinking (V) of said copolymer (b1) obtained in step (i);
(iii) polymerizing a modified monomer mixture to produce a modified copolymer (b1'), wherein the parameters of the polymerization reaction are adapted according to said crosslinking (V) determined as per step (ii) for said copolymer (b1) and according to the desired crosslinking (V') of said copolymer (b1') as graft substrate; and
(iv) repeating said steps (i) to (iii) as often as necessary until a desired degree of crosslinking (V') is obtained, and wherein
the transversal relaxation time T2 is used to determine said degree of crosslinking (V) of said copolymer (b1),
said degree of crosslinking (V) of said copolymer (b1) is determined by using a low-field NMR spectrometer at a field strength ranging from 0.001 to 1.5 teslas, preferably from 0.1 to 0.6 tesla, and
the T2 times for said graft substrates (b1) are in the range from 2.0 to 7 ms, as measured on filmed samples at 140°C,
**characterized in that** the step of providing said copolymer (b1') according to said degree of crosslinking (V) determined in step (ii) for said copolymer (b1) resulting from the first polymerization reaction is carried out by admixing the reaction mixture of the polymerization reaction as per step (iii) additionally with a polyfunctional crosslinking monomer (b13) as crosslinking agent and/or a chain transfer agent (b14), or changing the reaction temperature in the polymerization reaction, or a combination thereof.

5. Process according to any one of Claims 1, 2 and 3 or according to Claim 4, **characterized in that** the step of providing said copolymer (b1') is carried out by subjecting the reaction mixture of the polymerization reaction to a temperature change by not less than 10°C.

6. Process according to any one of Claims 1, 2, 3 and 5 or according to either of Claims 4 and 5, **characterized in that** the reaction mixture has added to it a chain transfer agent in an amount of 0.1 to 0.6 wt%, based on the entire monomer quantity of the polymerization mixture for producing said copolymer (b1').

## Revendications

1. Procédé d'optimisation du degré de réticulation (V) d'un copolymère réticulé (b1) en tant que base de greffage pour un modificateur de la résistance aux impacts polymère (b), fabriqué à partir d'un mélange de monomères, comprenant :
(b11) : 70 à 99,99 % en poids d'au moins un diène conjugué et/ou d'au moins un acrylate,
(b12) : 0 à 29 % en poids d'au moins un comonomère supplémentaire choisi parmi : le styrène, l'a-méthylstyrène, l'acrylonitrile, le méthacrylonitrile et le méthacrylate de méthyle,
(b13) : 0 à 10 % en poids d'un ou de plusieurs monomères réticulants polyfonctionnels, et
(b14) : 0,01 à 0,7 % en poids d'un réactif de transfert de chaînes,
par rapport à la quantité de monomères totale du mélange de polymérisation pour la fabrication du copolymère (b1) ;
le procédé comprenant les étapes suivantes :
(i) la polymérisation du mélange de monomères pour la fabrication du copolymère (b1) ;
(ii) la détermination du degré de réticulation (V) du copolymère (b1) obtenu à l'étape (i) au moyen de mesures de relaxation de RMN ;
(iii) la polymérisation d'un mélange de monomères modifié pour la fabrication d'un copolymère modifié (b1'), les paramètres de la réaction de polymérisation étant adaptés en fonction du degré de réticulation (V) du copolymère (b1) déterminé selon l'étape (ii) et du degré de réticulation souhaité (V') du copolymère (b1') en tant que base de greffage ; et
(iv) éventuellement la répétition des étapes (i) à (iii), jusqu'à ce qu'un degré de réticulation souhaité (V') soit obtenu, et
pour la détermination du degré de réticulation (V) du copolymère (b1), le temps de relaxation transversal T2 mesuré sur des dispersions de polymères liquides à une température de 20 °C à 50 °C étant utilisé, et
la détermination du degré de réticulation (V) du copolymère (b1) ayant lieu en utilisant un spectromètre RMN en champ faible à une puissance de champ dans la plage allant de 0,001 à 1,5 Tesla, de préférence de 0,1 à 0,6 Tesla.

2. Procédé selon la revendication 1, **caractérisé en ce que** le temps de relaxation T2 mesuré sur des dispersions de polymères liquides est déterminé au moyen d'une méthode séquentielle SE-CPMG (Solid Echo Carr Purcell Meiboom Gill).

3. Procédé selon la revendication 1 ou 2, **caractérisé en ce que**, pour la préparation du copolymère (b1'), un monomère réticulant polyfonctionnel (b13) en tant qu'agent de réticulation et/ou un réactif de transfert de chaînes (b14) sont en outre ajoutés au mélange réactionnel de la réaction de polymérisation selon l'étape (iii) en fonction du degré de réticulation (V) du copolymère (b1) déterminé à partir de la première réaction de polymérisation selon l'étape (ii), ou la température de réaction lors de la réaction de polymérisation est modifiée, ou une combinaison de ces mesures a lieu.

4. Procédé d'optimisation du degré de réticulation (V) d'un copolymère réticulé (b1) en tant que base de greffage pour un modificateur de la résistance aux impacts polymère (b), fabriqué à partir d'un mélange de monomères, comprenant :
(b11) : 70 à 99,99 % en poids d'au moins un diène conjugué et/ou d'au moins un acrylate,
(b12) : 0 à 29 % en poids d'au moins un comonomère supplémentaire choisi parmi : le styrène, l'a-méthylstyrène, l'acrylonitrile, le méthacrylonitrile et le méthacrylate de méthyle,
(b13) : 0 à 10 % en poids d'un ou de plusieurs monomères réticulants polyfonctionnels, et
(b14) : 0,01 à 0,7 % en poids d'un réactif de transfert de chaînes,
par rapport à la quantité de monomères totale du mélange de polymérisation pour la fabrication du copolymère (b1) ;
le procédé comprenant les étapes suivantes :
(i) la polymérisation du mélange de monomères pour la fabrication du copolymère (b1) ;
(ii) la détermination du degré de réticulation (V) du copolymère (b1) obtenu à l'étape (i) au moyen de mesures de relaxation de RMN ;
(iii) la polymérisation d'un mélange de monomères modifié pour la fabrication d'un copolymère modifié (b1'), les paramètres de la réaction de polymérisation étant adaptés en fonction du degré de réticulation (V) du copolymère (b1) déterminé selon l'étape (ii) et du degré de réticulation souhaité (V') du copolymère (b1') en tant que base de greffage ; et
(iv) éventuellement la répétition des étapes (i) à (iii), jusqu'à ce qu'un degré de réticulation souhaité (V') soit obtenu, et
pour la détermination du degré de réticulation (V) du copolymère (b1), le temps de relaxation transversal T2 étant utilisé,
la détermination du degré de réticulation (V) du copolymère (b1) ayant lieu en utilisant un spectromètre RMN en champ faible à une puissance de champ dans la plage allant de 0,001 à 1,5 Tesla, de préférence de 0,1 à 0,6 Tesla, et
les temps T2 pour les bases de greffage (b1) se situant dans la plage allant de 2,0 à 7 ms, mesurés sur des échantillons mis sous la forme de films à 140 °C,
**caractérisé en ce que**, pour la préparation du copolymère (b1'), un monomère réticulant polyfonctionnel (b13) en tant qu'agent de réticulation et/ou un réactif de transfert de chaînes (b14) sont en outre ajoutés au mélange réactionnel de la réaction de polymérisation selon l'étape (iii) en fonction du degré de réticulation (V) du copolymère (b1) déterminé à partir de la première réaction de polymérisation selon l'étape (ii), ou la température de réaction lors de la réaction de polymérisation est modifiée, ou une combinaison de ces mesures a lieu.

5. Procédé selon l'une quelconque des revendications 1, 2 et 3 ou selon la revendication 4, **caractérisé en ce que**, pour la préparation du copolymère (b1'), le mélange réactionnel de la réaction de polymérisation est soumis à une modification de température d'au moins 10 °C.

6. Procédé selon l'une quelconque des revendications 1, 2, 3 et 5 ou selon l'une quelconque des revendications 4 et 5, **caractérisé en ce qu'**un réactif de transfert de chaînes est ajouté au mélange réactionnel en une quantité de 0,1 à 0,6 % en poids, par rapport à la quantité de monomères totale du mélange de polymérisation pour la fabrication du copolymère (b1').
